# EUROPEAN PATENT APPLICATION

(11) **EP 4 542 647 A1**
(43) Date of publication of application: **23.04.2025**
(21) Application number: 23826795.9
(22) Date of filing: 25.04.2023
(51) Int. Cl.: H01L 25/07, H01L 25/065, H01L 25/18, H01L 27/146

(54) **PACKAGE, SEMICONDUCTOR DEVICE, AND METHOD FOR PRODUCING PACKAGE**

(30) Priority: 20.06.2022 JP 2022098955
(71) Applicant: Sony Semiconductor Solutions Corporation, Atsugi-shi, Kanagawa 243-0014 (JP)
(72) Inventor: SHIGETOSHI. Takushi, Atsugi-shi, Kanagawa 243-0014 (JP); SHIMIZU, Kan, Atsugi-shi, Kanagawa 243-0014 (JP); YOSHIOKA, Hirotaka, Atsugi-shi, Kanagawa 243-0014 (JP); MATSUGAI, Hiroyasu, Atsugi-shi, Kanagawa 243-0014 (JP)
(74) Representative: MFG Patentanwälte Meyer-Wildhagen Meggle-Freund Gerhard PartG mbB
(86) International application number: PCT/JP2023/016298
(87) International publication number: WO 2023/248606

(57) **Abstract**

The restriction of a lead-out position of a wire from a chip is relaxed.

A package includes a first chip, a second chip, and an extended rewiring layer. A first wiring layer is formed on a front surface of the first chip. The second chip has a front surface on which a second wiring layer is formed, and is shorter in length at least in a lateral direction than the first chip. The extended rewiring layer is extended in the lateral direction from the second chip and is electrically connected to the first wiring layer and the second wiring layer. A size of the extended rewiring layer may be equal to a size of the front surface of the first chip. The extended rewiring layer may be directly bonded to the first wiring layer.

## Description

### TECHNICAL FIELD

The present technology relates to a package, a semiconductor device, and a method for manufacturing a package. Specifically, the present technology relates to a package and a wiring structure of a semiconductor device.

### BACKGROUND ART

In packaging of a semiconductor chip, a three-dimensional integrated structure in which divided semiconductor chips are stacked may be used in order to suppress an increase in a mounting area. As such a three-dimensional integrated structure, for example, there is a structure in which wiring layers of a first chip and a second chip having the same size are stacked so as to face each other (see, for example, Patent Document 1). In addition, there is a structure in which a first chip and a second chip having the same size are stacked with an adhesive layer interposed therebetween (see, for example, Patent Document 2).

### CITATION LIST

### PATENT DOCUMENT

Patent Document 1: US Patent No. 10651224
Patent Document 2: US Patent No. 10734430

### SUMMARY OF THE INVENTION

### PROBLEMS TO BE SOLVED BY THE INVENTION

However, in the above-described conventional technique, in a case where a chip size is small, a wiring region of a chip is also small, and thus, there is a possibility that the restriction of a lead-out position of a wire from the chip increases.

The present technology has been made in view of such circumstances, and an object of the present technology is to relax the restriction of a lead-out position of a wire from a chip.

### SOLUTIONS TO PROBLEMS

The present technology has been made to solve the above problems, and a first aspect of the present technology is a package including a first chip having a front surface on which a first wiring layer is formed, a second chip having a front surface on which a second wiring layer is formed and having at least a length in a lateral direction that is shorter than the first chip, and an extended rewiring layer extended in the lateral direction from the second chip and electrically connected to the first wiring layer and the second wiring layer. Thus, there is brought about an effect that the restriction on a lead-out position of a wire from the second chip is relaxed.

In addition, in the first aspect, a size of the extended rewiring layer may be equal to a size of the front surface of the first chip. Thus, there is brought about an effect that the first chip, the second chip, and the extended rewiring layer are cut out collectively.

In addition, in the first aspect, the extended rewiring layer may be directly bonded to the first wiring layer. Thus, there is brought about an effect that a gap between the first wiring layer and the second wiring layer is reduced.

In addition, the first aspect may further include a support member that supports the extended rewiring layer on an extended region extended in the lateral direction from a mounting region of the second chip. Thus, there is brought about an effect that an extended rewiring layer larger than a size of the second chip is formed.

In addition, in the first aspect, the support member may include at least one of a protective film or a dummy chip. Thus, there is brought about an effect that the extended rewiring layer is supported on the extended region extended in the lateral direction from the mounting region of the second chip.

In addition, the first aspect may further include a through electrode formed in at least one of the first chip, the second chip, or the support member. Thus, there is brought about an effect that the wires of the first chip and the second chip are led out to outside.

In addition, the first aspect may further include an external connection terminal connected to the extended rewiring layer via a through hole formed in the support member. Thus, there is brought about an effect that the wires of the first chip and the second chip are led out to the outside while eliminating the need for the through electrode.

In addition, the first aspect may further include an extended back surface rewiring layer extended in the lateral direction from the second chip and formed on a back surface side of the second chip. Thus, there is brought about an effect that the wire of the second chip is led out from the back surface side of the second chip to the outside.

In addition, the first aspect may further include a third chip that is flip-chip mounted on the extended back surface rewiring layer and has a front surface on which a third wiring layer is formed. Thus, there is brought about an effect that the third chip is mounted without increasing the mounting area.

In addition, in the first aspect, the third wiring layer may be directly bonded to the extended back surface rewiring layer or bonded to the extended back surface rewiring layer via a bump. Thus, there is brought about an effect that the third chip is electrically connected to the second chip.

In addition, the first aspect may further include a back surface support member that supports the extended back surface rewiring layer on the back surface side of the second chip in an extended region extended in the lateral direction from the mounting region of the second chip. Thus, there is brought about an effect that an extended back surface rewiring layer larger than the size of the second chip is formed.

In addition, in the first aspect, the back surface support member may include at least one of a protective film or a dummy chip. Thus, there is brought about an effect that the extended back surface rewiring layer is supported on the back surface side of the second chip in the extended region extended in the lateral direction from the mounting region of the second chip.

In addition, the first aspect may further include a through electrode formed in at least one of the third chip or the back surface support member. Thus, there is brought about an effect that the wires of the first chip and the second chip are led out from the back surface side of the second chip to the outside.

In addition, the first aspect may further include a support substrate provided on a back surface side of the third chip. Thus, there is brought about an effect that the stacked structure of the first chip, the second chip, and the third chip is reinforced.

In addition, in the first aspect, any one of the first chip or the second chip may be an optical chip disposed in an uppermost layer. Thus, there is brought about an effect that the optical chip is stacked while allowing light to enter or exit from the outside.

In addition, the first aspect may further include a transparent resin formed on the optical chip. Thus, there is brought about an effect that the optical chip is sealed while allowing light to enter or exit from the outside.

In addition, the first aspect may further include a transparent substrate disposed on the transparent resin. Thus, there is brought about an effect that the optical chip is sealed while allowing light to enter or exit from the outside.

In addition, the first aspect may further include a fourth chip in which a fourth wiring layer is formed by being stacked on a back surface of the first chip via an adhesive layer. Thus, there is brought about an effect that the number of stacked chips is increased.

In addition, the first aspect may further include a light shielding film formed at a position in contact with the adhesive layer. Thus, there is brought about an effect that incidence of light from a surface opposite to the light receiving surface is blocked.

In addition, the first aspect may further include a through electrode that penetrates the first chip and the adhesive layer and electrically connects the first wiring layer and the fourth wiring layer, and an insulating layer that insulates the through electrode from a semiconductor layer of the first chip, in which the adhesive layer recedes from the semiconductor layer of the first chip at an embedded position of the through electrode, and a film thickness of the insulating layer at a position of the adhesive layer is thicker than a film thickness of the insulating layer at a position of the semiconductor layer. Thus, there is brought about an effect that a receding portion of the adhesive layer is backfilled with the insulating layer.

In addition, in the first aspect, a relationship of a<b may be satisfied when a film thickness of the adhesive layer is a, and the film thickness of the insulating layer at the position of the semiconductor layer is b. Thus, there is brought about an effect that the receding portion of the adhesive layer is completely backfilled with the insulating layer.

In addition, the first aspect may further include a pad electrode to which the through electrode is connected, and a plurality of vias connected to a surface of the pad electrode opposite to a surface to which the through electrode is connected. Thus, there is brought about an effect that an influence of stress caused by the through electrode is alleviated.

In addition, the first aspect may further include a pad electrode to which the through electrode is connected, and a via connected to a surface of the pad electrode opposite to a surface to which the through electrode is connected at a position separated from an axis of the through electrode. Thus, there is brought about an effect that stress applied from the through electrode to the via is alleviated.

In addition, the first aspect may further include a pad electrode to which the through electrode is connected, and an etch stopper layer formed on the pad electrode and provided with a through hole through which the through electrode passes. Thus, there is brought about an effect that the through electrode is connected to the pad electrode by self-alignment.

Furthermore, a second aspect is a semiconductor device including a first chip having a front surface on which a first wiring layer is formed and including through electrodes having different diameters and electrically connected to the first wiring layer, a second chip having a front surface on which a second wiring layer is formed, the second chip being stacked on the first chip so that the first wiring layer and the second wiring layer face each other. Thus, there is brought about an effect that the restriction on the arrangement of the through electrodes is relaxed.

In addition, the second aspect may further include a back surface wire formed on a back surface of the first chip, and a third chip flip-chip mounted on the back surface wire. Thus, there is brought about an effect that the third chip is mounted without increasing the mounting area.

In addition, the second aspect may further include an embedded wire embedded in the semiconductor layer of the first chip, in which a through electrode having a smaller diameter of the through electrodes having different diameters is electrically connected to the first wiring layer via the embedded wire. Thus, there is brought about an effect that an aspect ratio of the through electrode having a smaller diameter of the through electrodes having different diameters is reduced.

In addition, in the second aspect, the through electrode may include a first through electrode connected to a signal line, and a second through electrode connected to a power supply line and having a diameter larger than a diameter of the first through electrode. Thus, there is brought about an effect that a power supply can be stabilized while relaxing the restriction of a wiring position of the signal line.

Furthermore, a third aspect is a semiconductor device including a first chip having a front surface on which a first wiring layer including a plurality of pad electrodes is formed, the first chip including different numbers of through electrodes in contact with the pad electrodes, a second chip having a front surface on which a second wiring layer is formed, the second chip being stacked on the first chip so that the first wiring layer and the second wiring layer face each other. Thus, there is brought about an effect that a resistance is set for every through electrode while achieving uniform embeddability of the through electrode.

In addition, the third aspect may further include a back surface wire formed on the back surface of the first chip, and a third chip flip-chip mounted on the back surface wire. Thus, there is brought about an effect that the third chip is mounted without increasing the mounting area.

In addition, the third aspect may further include an embedded wire embedded in the semiconductor layer of the first chip, in which one through electrode in contact with the pad electrodes, of the different numbers of through electrodes in contact with the pad electrodes, is electrically connected to the first wiring layer via the embedded wire. Thus, there is brought about an effect that an aspect ratio of one through electrode in contact with the pad electrodes, of the different numbers of through electrodes in contact with the pad electrodes, is reduced.

In addition, in the third aspect, a diameter of a smaller number of through electrodes in contact with the pad electrodes may be smaller than a diameter of a larger number of through electrodes in contact with the pad electrodes of the different numbers of through electrodes in contact with the pad electrodes. Thus, there is brought about an effect that the restriction on the arrangement of the through electrodes is relaxed.

Furthermore, a fourth aspect is a method for manufacturing a package, the method including steps of forming a first wiring layer on a wafer to be divided into solid pieces of a first chip, arranging a second chip on a support substrate wafer, the second chip having a second wiring layer and being smaller in size than a front surface of the first chip, forming a support member on the support substrate wafer, the support member being adjacent to the second chip so as to be equal in size to the front surface of the first chip and being equal in height to the second chip, forming an extended rewiring layer equal in size to the front surface of the first chip on the second wiring layer and the support member, electrically connecting the first wiring layer and the second wiring layer such that the first wiring layer and the second wiring layer face each other via the extended rewiring layer, and dividing the package into solid pieces of packages in which the second chip is stacked on the first chip via the extended rewiring layer. Thus, there is brought about an effect that the first chips and the second chips having different sizes are collectively divided into solid pieces in a stacked state.

In addition, the fourth aspect may further include steps of forming a first through electrode connected to the first wiring layer in the first chip, forming a second through electrode connected to the second wiring layer in the second chip, forming an extended back surface rewiring layer on a back surface of the second chip and a back surface of the support member, the extended back surface rewiring layer being allowed to be cut out so as to be equal in size to the front surface of the first chip, and flip-chip mounting a third chip having a front surface on which a third wiring layer is formed on the extended back surface rewiring layer, in which the package is divided into solid pieces of packages in which the second chip is stacked on the first chip via the extended rewiring layer and the third chip is stacked on the second chip via the extended back surface rewiring layer. Thus, there is brought about an effect that the first chips, the second chips, and the third chips having different sizes are collectively divided into solid pieces in a stacked state.

In addition, the fourth aspect may further include forming an extended back surface rewiring layer on a back surface of the second chip and a back surface of the support member, the extended back surface rewiring layer being allowed to be cut out so as to be equal in size to the front surface of the first chip, flip-chip mounting a third chip on the extended back surface rewiring layer, the third chip having a third wiring layer and being smaller in size than the front surface of the first chip, forming a back surface support member adjacent to the third chip on the extended back surface rewiring layer so as to be equal in size to the front surface of the first chip, and forming a through electrode in at least one of the third chip or the back surface support member, in which the package is divided into solid pieces of packages in which the second chip is stacked on the first chip via the extended rewiring layer and the third chip is stacked on the second chip via the extended back surface rewiring layer. Thus, there is brought about an effect that the first chips, the second chips, and the third chips having different sizes are collectively divided into solid pieces in a stacked state while enabling electrical connection to the outside from the back surface side of the package.

### BRIEF DESCRIPTION OF DRAWINGS

Fig. 1 is a sectional view illustrating a configuration example of a package according to a first embodiment.
Fig. 2 is a plan view illustrating a configuration example of a dummy chip according to the first embodiment.
Fig. 3 is a plan view illustrating another example of the dummy chip according to the first embodiment.
Fig. 4 is a plan view illustrating another example of the dummy chip according to the first embodiment.
Fig. 5 is a first sectional view and a plan view illustrating an example of a method for manufacturing a package according to the first embodiment.
Fig. 6 is a second sectional view illustrating an example of the method for manufacturing a package according to the first embodiment.
Fig. 7 is a third sectional view illustrating an example of the method for manufacturing a package according to the first embodiment.
Fig. 8 is a fourth sectional view illustrating an example of the method for manufacturing a package according to the first embodiment.
Fig. 9 is a fifth sectional view illustrating an example of the method for manufacturing a package according to the first embodiment.
Fig. 10 is a sixth sectional view illustrating an example of the method for manufacturing a package according to the first embodiment.
Fig. 11 is a seventh sectional view illustrating an example of the method for manufacturing a package according to the first embodiment.
Fig. 12 is an eighth sectional view illustrating an example of the method for manufacturing a package according to the first embodiment.
Fig. 13 is a ninth sectional view illustrating an example of the method for manufacturing a package according to the first embodiment.
Fig. 14 is a tenth sectional view illustrating an example of the method for manufacturing a package according to the first embodiment.
Fig. 15 is an eleventh sectional view illustrating an example of the method for manufacturing a package according to the first embodiment.
Fig. 16 is a twelfth sectional view illustrating an example of the method for manufacturing a package according to the first embodiment.
Fig. 17 is a sectional view illustrating a configuration example of a package according to a second embodiment.
Fig. 18 is a first sectional view illustrating an example of the method for manufacturing a package according to the second embodiment.
Fig. 19 is a second sectional view illustrating an example of the method for manufacturing a package according to the second embodiment.
Fig. 20 is a third sectional view illustrating an example of the method for manufacturing a package according to the second embodiment.
Fig. 21 is a fourth sectional view illustrating an example of the method for manufacturing a package according to the second embodiment.
Fig. 22 is a fifth sectional view illustrating an example of the method for manufacturing a package according to the second embodiment.
Fig. 23 is a sectional view illustrating a configuration example of a package according to a third embodiment.
Fig. 24 is a sectional view illustrating a configuration example of a package according to a fourth embodiment.
Fig. 25 is a sectional view illustrating a configuration example of a package according to a fifth embodiment.
Fig. 26 is a sectional view illustrating a configuration example of a package according to a sixth embodiment.
Fig. 27 is a sectional view illustrating a configuration example of a package according to a seventh embodiment.
Fig. 28 is a sectional view illustrating a configuration example of a package according to an eighth embodiment.
Fig. 29 is a first sectional view illustrating an example of a method for manufacturing a package according to the eighth embodiment.
Fig. 30 is a second sectional view illustrating an example of the method for manufacturing a package according to the eighth embodiment.
Fig. 31 is a third sectional view illustrating an example of the method for manufacturing a package according to the eighth embodiment.
Fig. 32 is a fourth sectional view illustrating an example of the method for manufacturing a package according to the eighth embodiment.
Fig. 33 is a fifth sectional view illustrating an example of the method for manufacturing a package according to the eighth embodiment.
Fig. 34 is a sixth sectional view illustrating an example of the method for manufacturing a package according to the eighth embodiment.
Fig. 35 is a seventh sectional view illustrating an example of the method for manufacturing a package according to the eighth embodiment.
Fig. 36 is a sectional view illustrating a configuration example of a package according to a ninth embodiment.
Fig. 37 is an enlarged sectional view illustrating a part of the package according to the ninth embodiment.
Fig. 38 is a sectional view illustrating an example of a method for manufacturing a through electrode of the package according to the ninth embodiment.
Fig. 39 is a sectional view illustrating a configuration example of a pad electrode of a package according to a tenth embodiment.
Fig. 40 is a sectional view illustrating a configuration example of a pad electrode of a package according to an eleventh embodiment.
Fig. 41 is a sectional view illustrating a configuration example of a package according to a twelfth embodiment.
Fig. 42 is a sectional view illustrating a configuration example of a package according to a thirteenth embodiment.
Fig. 43 is a sectional view illustrating a configuration example of a package according to a fourteenth embodiment.
Fig. 44 is a block diagram illustrating a schematic configuration example of a vehicle control system.
Fig. 45 is an explanatory diagram illustrating an example of an installation position of an imaging section.

### MODE FOR CARRYING OUT THE INVENTION

A mode for carrying out the present technology (hereinafter, referred to as an embodiment) will be described below. The description will be given in the following order.
1. First embodiment (an example in which first chip is mounted on extended rewiring layer extended from second chip)
2. Second embodiment (example in which first chip is mounted on extended rewiring layer extended from second chip, third chip is mounted on extended back surface rewiring layer extended from second chip, and through electrode connected to extended back surface rewiring layer is connected to outside)
3. Third embodiment (example in which first chip is mounted on extended rewiring layer extended from second chip, third chip is mounted on extended back surface rewiring layer extended from second chip, and through electrode connected to extended back surface rewiring layer is formed on protective film)
4. Fourth embodiment (example in which first chip is mounted on extended rewiring layer extended from second chip, and through electrode connected to extended rewiring layer is formed around second chip)
5. Fifth embodiment (example in which second chip is mounted on extended rewiring layer extended from first chip, and external connection terminal formed around first chip is connected to extended rewiring layer)
6. Sixth Embodiment (Example in which first chip and second chip are directly bonded, and extended rewiring layer extended from third chip is connected to back surface wiring layer of second chip)
7. Seventh embodiment (example in which five-layer stacked structure of chip is formed by using extended rewiring layer and extended back surface rewiring layer)
8. Eighth embodiment (example in which first chip and second chip are bonded via adhesive layer, and extended rewiring layer extended from third chip is connected to wiring layer of second chip)
9. Ninth embodiment (example in which first chip and second chip are bonded via adhesive layer, and insulating layer of through electrode penetrating second chip is embedded in receding portion of adhesive layer)
10. Tenth embodiment (example in which via formed in pad electrode to which through electrode is connected is disposed to be separated from axis of through electrode)
11. Eleventh embodiment (example in which etch stopper layer is provided on pad electrode to which through electrode is connected, and opening is provided at position to which through electrode is connected)
12. Twelfth embodiment (example in which plurality of through electrodes having different diameters is provided on chip)
13. Thirteenth embodiment (example in which plurality of through electrodes having different diameters is provided on a chip and through electrode is connected to embedded wire of chip)
14. Fourteenth embodiment (example in which numbers of through electrodes connected to pad electrodes provided on chip are different from each other)
15. Application example to mobile object

### <1. First embodiment>

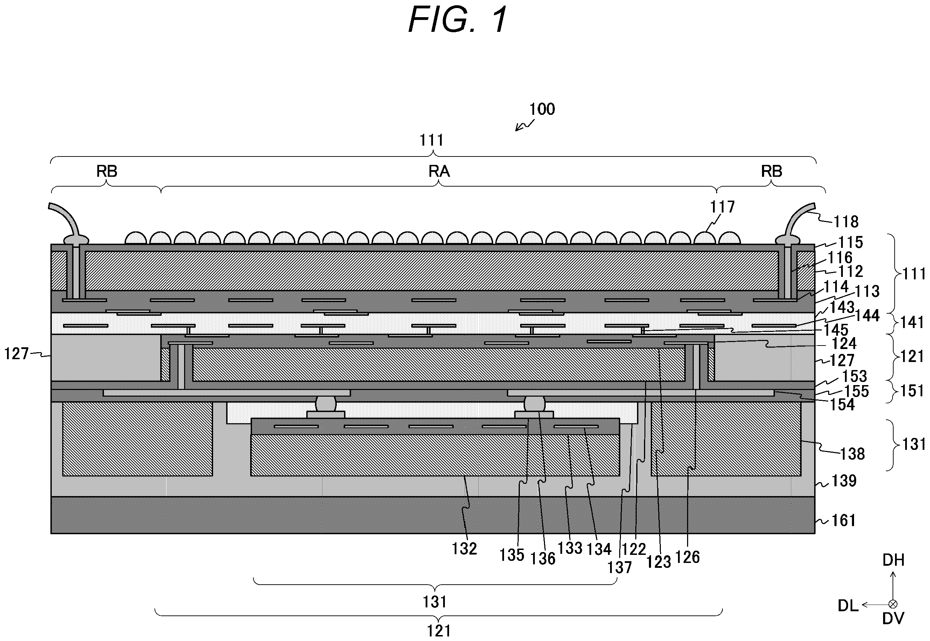

Fig. 1 is a sectional view illustrating a configuration example of a package according to a first embodiment.

In the drawing, a package 100 includes chips 111, 121, and 131, an extended rewiring layer 141, and an extended back surface rewiring layer 151. Each of the chips 121 and 131 is shorter in length at least in a lateral direction DL than the chip 111. As for a length in a vertical direction DV, each of the chips 121 and 131 may be shorter, longer, or equal to the chip 111.

The chips 111, 121, and 131 can constitute a three-layer stacked structure stacked in a height direction DH. At this time, the extended rewiring layer 141 is provided on a front surface side of the chip 121 and is extended from the chip 121 in the lateral direction DL. The extended back surface rewiring layer 151 is provided on a back surface side of the chip 121 and is extended from the chip 121 in the lateral direction DL. Then, the chips 111 and 121 are electrically connected to each other via the extended rewiring layer 141, and the chips 121 and 131 are electrically connected to each other via the extended back surface rewiring layer 151.

Each of the chips 111, 121, and 131 may be a semiconductor chip or may include an optical chip. At this time, the optical chip can be used as an uppermost-layer chip provided in the package 100.

An optical element is formed on the optical chip. The optical element may be a solid-state imaging element such as a charged coupled device (CCD) or a complementary metal-oxide semiconductor (CMOS). The light received by the solid-state imaging element may be visible light, near infrared light (NIR), short wavelength infrared light (SWIR), ultraviolet light, X-ray, or the like. The optical element may be a light receiving element such as a photo diode (PD), or may be a light emitting element such as a laser diode (LD), a light emitting diode (LED), or a vertical cavity surface emitting laser (VCSEL). The optical element may be a micro electro mechanical systems (MEMS) element such as an optical switch or a mirror device. The material used for the base material of the optical chip may be a semiconductor such as Si, GaAS, or InGaAsP, or may be a dielectric such as LiNbO₃ glass, or a transparent resin.

A semiconductor element is formed on the semiconductor chip. The semiconductor element may include a transistor, a resistor, a capacitor, and the like. In the semiconductor chip, a memory may be formed, a processor may be formed, a signal processing circuit may be formed, a data processing circuit may be formed, an interface circuit may be formed, or an optical element may be formed. In the semiconductor chip, for example, a hardware circuit such as a field-programmable gate array (FPGA) or an application specific integrated circuit (ASIC) may be formed. The material used for the base material of the semiconductor chip may be Si, GaAS, SiC, GaN, InGaAsP, or the like.

In the following description, a case will be taken as an example where a back surface irradiation-type solid-state imaging element is formed on the chip 111, and a semiconductor element is formed on each of the chips 121 and 131.

The chip 111 includes a semiconductor layer 112 and a wiring layer 113. The semiconductor layer 112 is provided with an imaging region and a non-imaging region. In the imaging region, pixels and pixel transistors disposed in a matrix along a row direction and a column direction are disposed. In the non-imaging region, a peripheral circuit that drives the pixel transistor and outputs a signal read from the pixel is provided.

The wiring layer 113 is formed on the front surface side of the semiconductor layer 112. The wiring layer 113 is provided with a wire and a pad electrode 114 embedded in an insulating layer. In addition, a through electrode 116 is embedded in the semiconductor layer 112. The through electrode 116 is connected to the pad electrode 114 of the wiring layer 113. In addition, a protective film 115 is formed on the back surface side of the semiconductor layer 112. At this time, the protective film 115 is formed in the semiconductor layer 112 so as to surround an outer periphery of the through electrode 116, and can insulate the through electrode 116 from the semiconductor layer 112. A bonding wire 118 is connected to the through electrode 116 in order to be connected to the outside.

An on-chip lens 117 is formed on the protective film 115 for every pixel. As the material of the on-chip lens 117, for example, a transparent resin such as acrylic or polycarbonate can be used. Note that a color filter may be provided for every pixel between the semiconductor layer 112 and the on-chip lens 117. At this time, the color filter can constitute, for example, a Bayer array.

The chip 121 includes a semiconductor layer 122 and a wiring layer 123. The wiring layer 123 is formed on the semiconductor layer 122. The wiring layer 123 is provided with a wire and a pad electrode 124 embedded in an insulating layer. In addition, a through electrode 126 is embedded in the semiconductor layer 122. The through electrode 126 is connected to the pad electrode 124 of the wiring layer 123. In addition, a protective film 127 is formed in the lateral direction DL of the chip 121. The protective film 127 can be in contact with a side surface of the chip 121. The position of a front surface of the protective film 127 in the height direction DH can be made substantially equal to the position of the front surface of the chip 121 in the height direction DH. In addition, the position of a back surface of the protective film 127 in the height direction DH can be made substantially equal to the position of the back surface of the chip 121 in the height direction DH. The position of an end of the protective film 127 in the lateral direction DL can coincide with the position of an end of the chip 111 in the lateral direction DL. The protective film 127 is an example of a support member described in the claims.

The chip 131 includes a semiconductor layer 132 and a wiring layer 133. The wiring layer 133 is formed on the semiconductor layer 132. The wiring layer 133 is provided with a wire 134 and a pad electrode 135 embedded in an insulating layer. A bump electrode 136 is formed on the pad electrode 135. Note that the bump electrode 136 may be a solder ball or a pillar electrode. In addition, each of the semiconductor layers 112, 122, and 132 may be a semiconductor substrate, a thinned semiconductor substrate, or a semiconductor layer used for a silicon on insulator (SOI) substrate.

As the material of the insulating layer used for each of the wiring layers 113, 123, and 133 and the protective film 115, for example, SiO₂ can be used. As the material of the wires and each of the pad electrodes 114, 124, and 135 used for the wiring layers 113, 123, and 133, for example, a metal such as Al or Cu can be used. As the material of the through electrodes 116 and 126, for example, a metal such as Cu, Ti, Ta, Al, W, Ni, Ru, or Co can be used, and a stacked structure of a plurality of materials may be used. As the material of the bonding wire 118, for example, a metal such as Au or Al can be used.

The extended rewiring layer 141 is extended from the chip 111 in the lateral direction DL so as to be equal to the length of the chip 121 in the lateral direction DL. At this time, the position of an end of the extended rewiring layer 141 in the lateral direction DL and the position of the end of the chip 111 in the lateral direction DL can coincide with each other. The extended rewiring layer 141 is extended from a mounting region RA of the chip 121 to an extended region RB extended in the lateral direction DL.

The extended rewiring layer 141 includes an insulating layer 143 and a rewire 144. The rewire 144 is embedded in the insulating layer 143. In addition, a via 145 that performs interlayer connection of the rewire 144 can be formed in the extended rewiring layer 141.

The chip 121 is disposed on one surface of the extended rewiring layer 141, and the protective film 127 is disposed in the extended region RB of the surface. The rewire 144 of the extended rewiring layer 141 can be connected to the wire of the wiring layer 123 via the via 145. At this time, the extended rewiring layer 141 can be supported by the chip 121 and the protective film 127.

The chip 111 is disposed on the other surface of the extended rewiring layer 141. At this time, the chip 111 and the extended rewiring layer 141 may be directly bonded such that the wiring layer 113 of the chip 111 faces the extended rewiring layer 141. In this direct bonding, hybrid bonding may be used. In this hybrid bonding, the wire exposed on a front surface of the wiring layer 113 and the wire exposed on a front surface of the extended rewiring layer 141 are formed at positions facing each other. At this time, Cu can be used as a material of these wires. In addition, each of the wire of the wiring layer 113 and the wire of the extended rewiring layer 141 is recessed by about several tens nm from a front surface of the insulating layer of the wiring layer 113 and a front surface of the insulating layer of the extended rewiring layer 141. Then, after front surface processing of these insulating layers is performed, the insulating layers are brought into facing contact with each other, so that the insulating layers are connected to each other. At this time, a slight gap is formed between the wire of the wiring layer 113 and the wire of the extended rewiring layer 141. Then, a heat treatment is performed in a state where the insulating layer of the wiring layer 113 and the insulating layer of the extended rewiring layer 141 are pressure-bonded to each other. Thus, the wire of the wiring layer 113 and the wire of the extended rewiring layer 141 expand, these wires come into contact with each other, Cu interdiffuses with each other, and bonding between the wires is formed.

The extended back surface rewiring layer 151 is extended from the chip 121 in the lateral direction DL so as to be equal to the length of the chip 111 in the lateral direction DL. At this time, the position of an end of the extended back surface rewiring layer 151 in the lateral direction DL and the position of the end of the chip 111 in the lateral direction DL can coincide with each other. The extended back surface rewiring layer 151 is extended from the mounting region RA of the chip 121 to the extended region RB extended in the lateral direction DL.

The extended back surface rewiring layer 151 includes an insulating layer 153, a back surface rewire 154, and a protective film 155. The insulating layer 153 is formed on the back surface of the semiconductor layer 112 and the protective film 127. At this time, the insulating layer 153 is formed in the semiconductor layer 122 so as to surround an outer periphery of the through electrode 126, and can insulate the through electrode 126 from the semiconductor layer 112. A back surface rewire 154 is formed on the insulating layer 153. The back surface rewire 154 can be electrically connected to the through electrode 126 and the bump electrode 136. The chip 131 is flip-chip mounted on the extended back surface rewiring layer 151 via the bump electrode 136. Note that the chip 131 may be directly bonded onto the extended back surface rewiring layer 151. In addition, the protective film 155 is formed on the insulating layer 153 so as to cover the back surface rewire 154.

The sizes of the front surfaces of the extended rewiring layer 141 and the extended back surface rewiring layer 151 may be equal to the size of the front surface of the chip 111. The fact that the sizes of the front surfaces are equal means that not only the length in the lateral direction DL but also the length in the vertical direction DV are equal to each other.

The extended rewiring layer 141 and the extended back surface rewiring layer 151 can be formed in a manner similar to a rewiring layer used for a fan out wafer level package (FOWLP).

As the material of the insulating layers 143 and 153 used for the extended rewiring layer 141 and the extended back surface rewiring layer 151, for example, a photosensitive insulating resin having SiO₂, SiON, SiN, SiOC or SiCN can be used in the case of an inorganic film, and a photosensitive insulating resin having silicone, polyimide, acrylic, epoxy or the like as a skeleton can be used in the case of an organic film. As the materials of the rewire 144, the back surface rewire 154, and the via 145, for example, metals such as Cu, Ti, Ta, Al, W, Ni, Ru, and Co can be used, and a laminated structure of a plurality of materials may be used.

An underfill 137 is provided between the extended back surface rewiring layer 151 and the chip 131. The material of the underfill 137 is, for example, a thermosetting resin such as an epoxy resin.

The dummy chip 138 is disposed around the chip 131. At this time, the dummy chip 138 can be mounted on the extended back surface rewiring layer 151 separately from the chip 131. The dummy chip 138 may be fixed to the extended back surface rewiring layer 151 via an adhesive layer. A front surface of the dummy chip 138 is flattened. The position of the flat surface of the dummy chip 138 in the height direction DH can be made substantially equal to the position of a top surface of the chip 131 in the height direction DH. The material of the dummy chip 138 may be a semiconductor such as Si or an inorganic material such as glass or ceramics. Note that the chip 131 may be disposed at a center of the dummy chip 138, or the dummy chip 138 may be disposed in a region including front, rear, left, and right ends. By arranging the dummy chip 138 on the extended back surface rewiring layer 151, a mechanical strength and heat dissipation from the back surface of the package 100 can be improved. Note that the arrangement position of the dummy chip 138 may be determined such that heat dissipation from the package 100 is made uniform. The dummy chip 138 is not required to be provided.

In addition, a protective film 139 is formed on the extended back surface rewiring layer 151 so as to cover the chip 131 and the dummy chip 138. A support substrate 161 is disposed on the protective film 139. At this time, the position of ends of the protective film 139 and the support substrate 161 in the lateral direction DL and the position of the end of the chip 111 in the lateral direction DL can coincide with each other. By arranging the support substrate 161 on the protective film 139, the mechanical strength and heat dissipation from the back surface of the package 100 can be improved. The dummy chip 138 and the protective film 139 are examples of back surface support members described in the claims.

The material of the protective films 127 and 139 includes an insulating layer of an inorganic or organic material, and a plurality of films may be stacked. Examples of the films include an inorganic film such as SiO₂, SiON, SiN, SiOC, or SiCN, an organic film such as a resin having silicone, polyimide, acrylic, or epoxy as a skeleton, and a material containing a filler such as SiO₂, Al₂O₃, AlN, or BN. The material of the support substrate 161 can be, for example, Si or glass. The material of the protective films 127 and 155 may be a molding material.

Note that a plurality of chips 121 may be provided, and a plurality of chips 131 may be provided. In a case where a plurality of chips 121 is provided, the plurality of chips 121 may be connected to each other via the extended rewiring layer 141. In a case where a plurality of chips 131 is provided, the plurality of chips 131 may be connected to each other via the extended back surface rewiring layer 151.

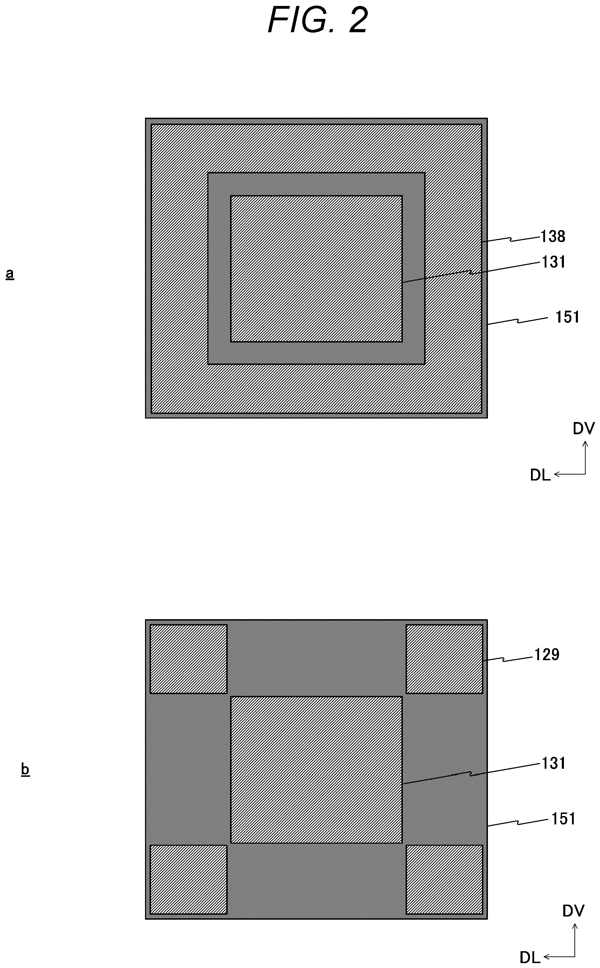

Figs. 2 to 4 are plan views illustrating modifications of the dummy chip according to the first embodiment.

In a of Fig. 2, one dummy chip 138 is disposed on the extended back surface rewiring layer 151 so as to surround a periphery of the chip 131.

In b of Fig. 2, four dummy chips 129 are disposed on the extended back surface rewiring layer 151 so as to be adjacent to the four corners of the chip 131.

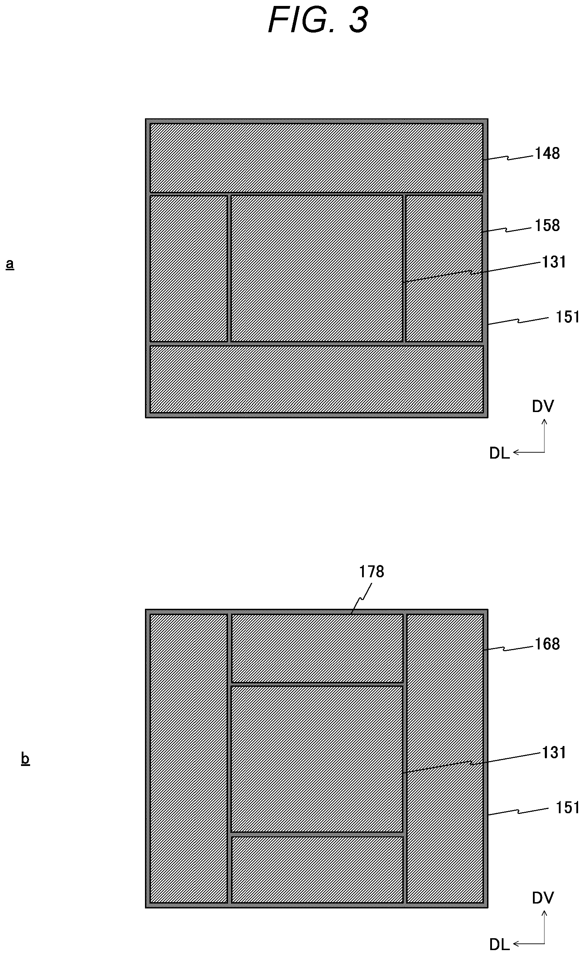

In a of Fig. 3, four dummy chip 148 and 158 are disposed on the extended back surface rewiring layer 151 apart from each other so as to surround the periphery of the chip 131. At this time, the length of the dummy chip 158 in the vertical direction DV is equal to the length of the chip 131 in the vertical direction DV.

In b of Fig. 3, four dummy chip 168 and 178 are disposed on the extended back surface rewiring layer 151 apart from each other so as to surround the periphery of the chip 131. At this time, the length of the dummy chip 178 in the lateral direction DL is equal to the length of the chip 131 in the lateral direction DL.

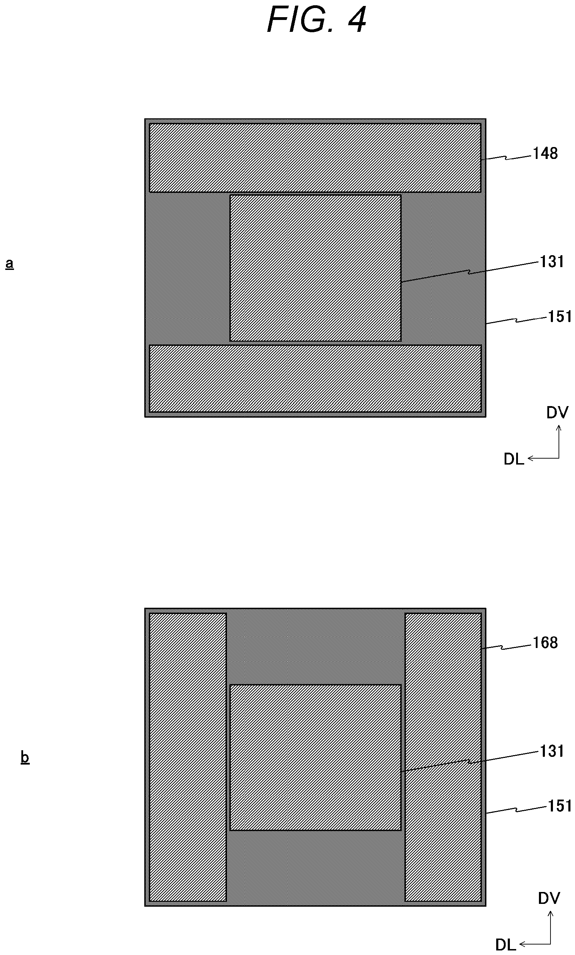

In a of Fig. 4, two dummy chips 148 are disposed on the extended back surface rewiring layer 151 so as to sandwich the chip 131 in the vertical direction DV. At this time, the length of the dummy chip 148 in the lateral direction DL is longer than the length of the chip 131 in the lateral direction DL.

In b of Fig. 4, two dummy chips 168 are disposed on the extended back surface rewiring layer 151 so as to sandwich the chip 131 in the lateral direction DL. At this time, the length of the dummy chip 168 in the vertical direction DV is longer than the length of the chip 131 in the vertical direction DV.

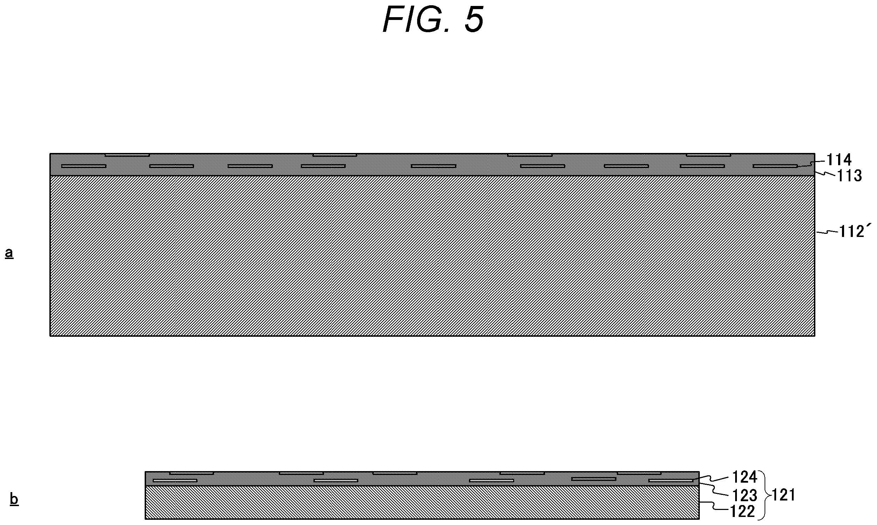

Figs. 5 to 16 are sectional views illustrating an example of a method for manufacturing a package according to the first embodiment.

In a of Fig. 5, the wiring layer 113 provided with the wire and the pad electrodes 114 is formed on a semiconductor wafer 112'. A plurality of chips 111 used for a plurality of packages 100 can be cut out from the semiconductor wafer 112'. At this time, in the semiconductor wafer 112', an optical element can be formed for every section from which the chip 111 is cut out. For example, the semiconductor wafer 112' may be sectioned along dicing lines used to divide the packages 100. In a case where a CMOS solid-state imaging element is formed on the chip 111, a photodiode and a pixel transistor can be formed for every section from which the chip 111 is cut out.

In addition, in b of Fig. 5, the semiconductor chip 121 in which the wiring layer 123 is provided on the semiconductor layer 122 is formed. Note that the semiconductor chip 121 can be divided into solid pieces from a semiconductor wafer on which a plurality of semiconductor chips 121 is integrally formed.

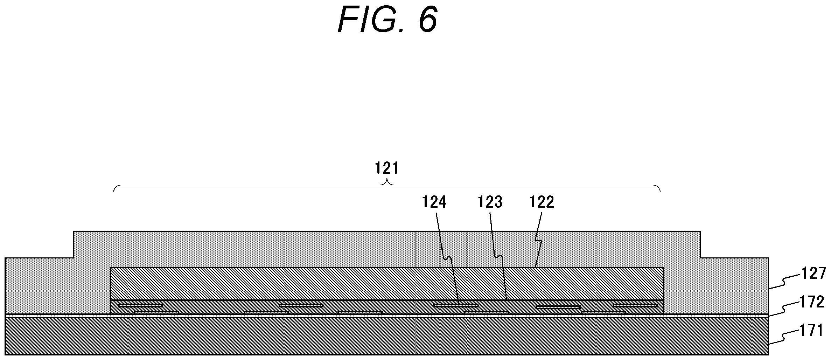

Next, as illustrated in Fig. 6, the semiconductor chip 121 is temporarily bonded to a support substrate wafer 171 via an adhesive layer 172. Note that the support substrate wafer 171 can have the same shape and size as the semiconductor wafer 112'. At this time, the plurality of semiconductor chips 121 can be temporarily bonded to the support substrate wafer 171 for every package 100 to be divided into solid pieces. Next, the protective film 127 is formed on the support substrate wafer 171 so as to cover the semiconductor chip 121. The protective film 127 may be formed by chemical vapor deposition (CVD), may be formed by coating, or may be formed by molding.

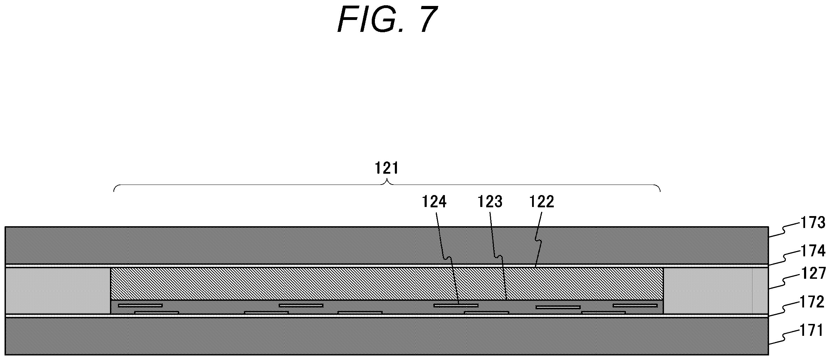

Next, as illustrated in Fig. 7, the protective film 127 is thinned until the semiconductor layer 122 of the semiconductor chip 121 is exposed, and the front surface of the protective film 127 is flattened. For thinning the protective film 127, a grinder, chemical mechanical polishing (CMP), or etch-back may be used. Next, the semiconductor layer 122 and the protective film 127 are temporarily bonded to a support substrate wafer 173 via an adhesive layer 174. The support substrate wafer 173 can have the same shape and size as the semiconductor wafer 112'.

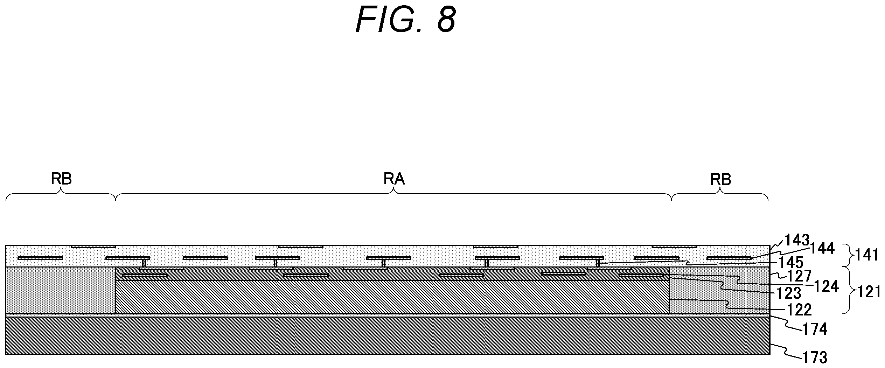

Next, as illustrated in Fig. 8, the support substrate wafer 171 on the wiring layer 123 side of the chip 121 is removed. Next, the extended rewiring layer 141 electrically connected to the wiring layer 123 of the chip 121 is formed on the chip 121 and the protective film 127. At this time, the extended rewiring layer 141 is extended from the mounting region RA of the chip 121 to the extended region RB.

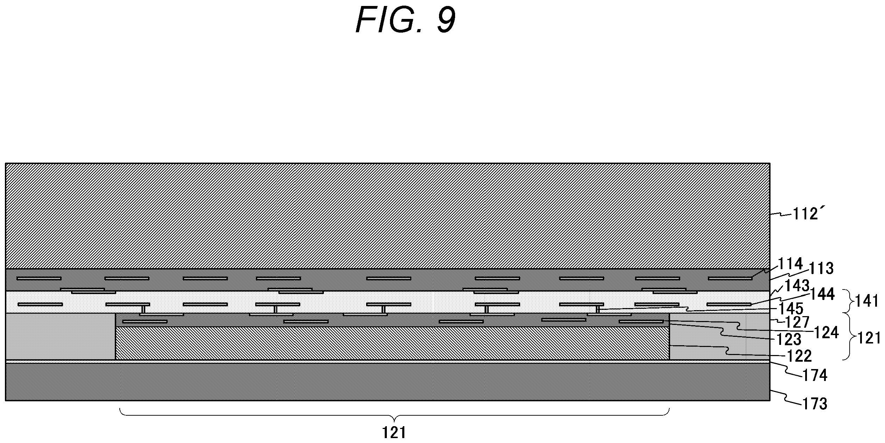

Next, as illustrated in Fig. 9, the wiring layer 113 and the extended rewiring layer 141 are directly bonded such that the wiring layer 113 formed on the semiconductor wafer 112' faces the extended rewiring layer 141.

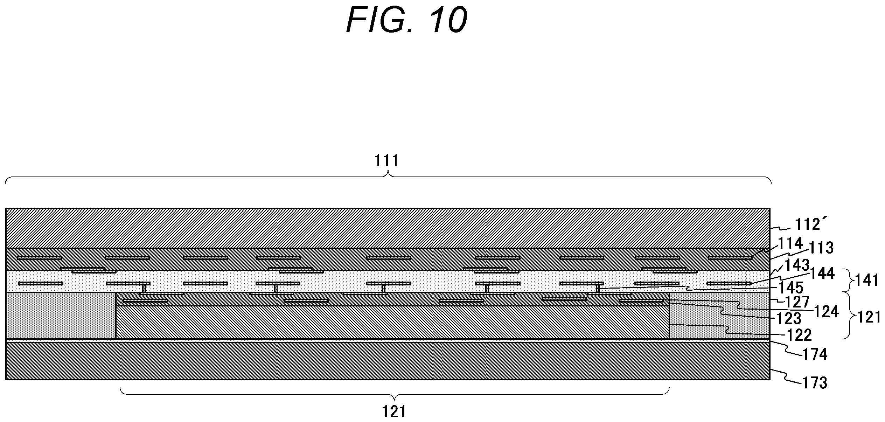

Next, as illustrated in Fig. 10, the semiconductor wafer 112' is thinned from a back surface side. In this thinning, for example, a grinder, CMP, dry etching, or wet etching may be used. In a case where a back surface irradiation-type individual imaging element is formed on the semiconductor wafer 112', an exposed surface of the thinned semiconductor wafer 112' becomes a light receiving surface.

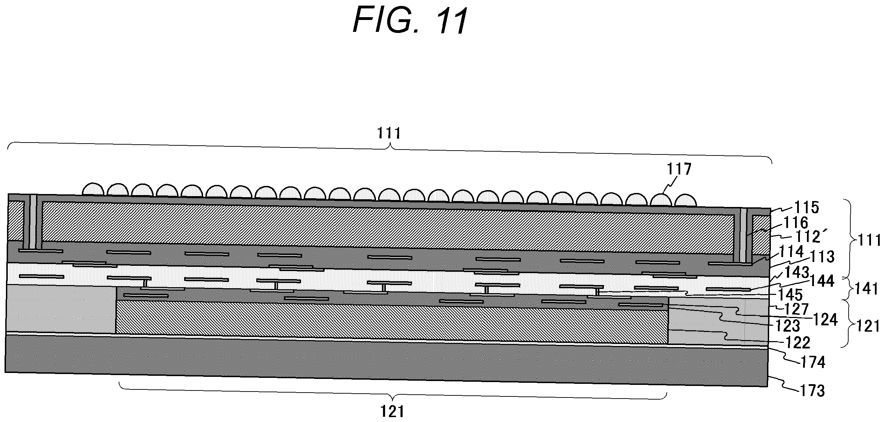

Next, as illustrated in Fig. 11, a through hole in which the through electrode 116 is embedded is formed in the semiconductor wafer 112' by using a method such as lithography and dry etching, and the pad electrode 114 of the wiring layer 113 is exposed through the through hole. Next, by using a method such as CVD, the protective film 115 is formed on the back surface side of the semiconductor wafer 112' so as to cover a side wall of the through hole. Then, the through electrode 116 embedded in the semiconductor wafer 112' via the protective film 115 is formed. Furthermore, the on-chip lens 117 is formed on the protective film 115. Note that an antireflection film and a color filter may be formed under the on-chip lens 117.

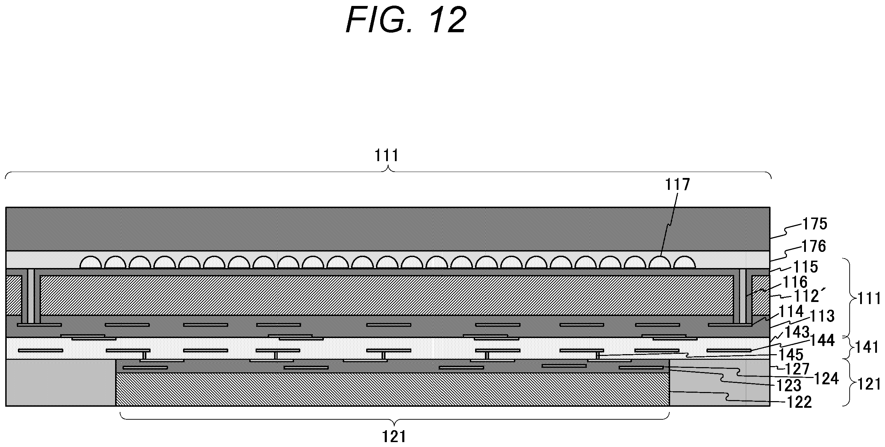

Next, as illustrated in Fig. 12, a support substrate wafer 175 is bonded to the semiconductor wafer 112' side via an adhesive layer 176. The support substrate wafer 175 can have the same shape and size as the semiconductor wafer 112'. Note that the adhesive layer 176 can be peeled off from the on-chip lens 117. In order to make the adhesive layer 176 peelable from the on-chip lens 117, an adhesive material whose adhesive force rapidly decreases on the basis of ultraviolet irradiation may be used as the adhesive layer 176. Next, the support substrate wafer 173 is removed from the semiconductor layer 122 and the protective film 127.

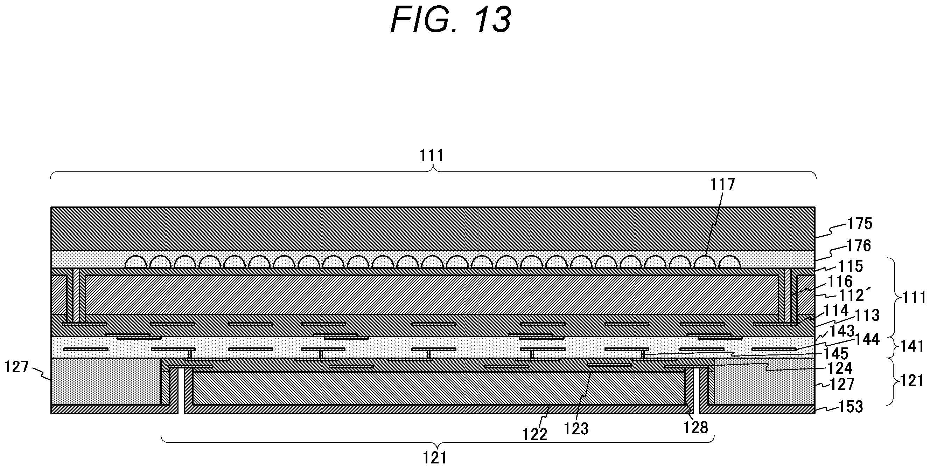

Next, as illustrated in Fig. 13, a through hole 128 is formed in the semiconductor layer 122 by using a method such as lithography and dry etching, and the pad electrode 124 of the wiring layer 123 is exposed through the through-hole 128. Then, by using a method such as plasma-enhanced (PE)-CVD, the insulating layer 153 extending on the protective film 127 is formed on the back surface side of the semiconductor layer 122 so as to cover a side wall of the through hole 128.

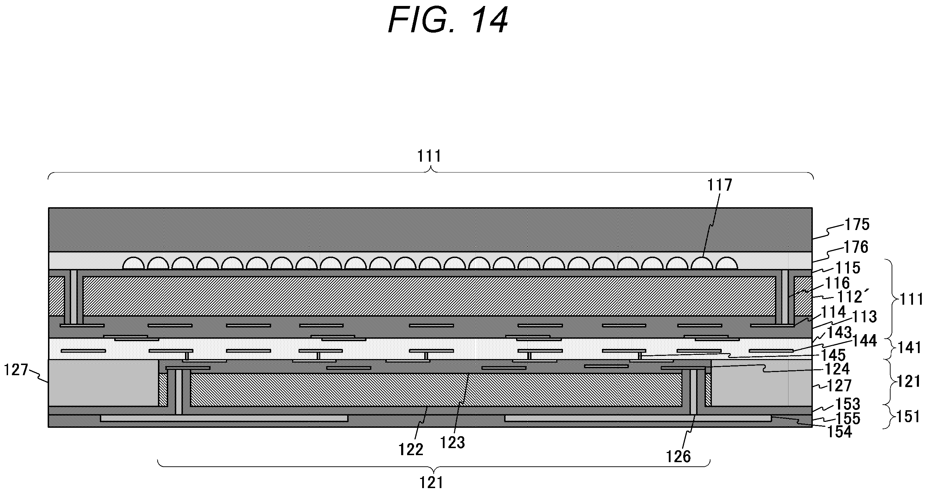

Next, as illustrated in Fig. 14, the through electrode 126 embedded in the through hole 128 via the insulating layer 153 is formed on the pad electrode 124. For the formation of the through electrode 126, for example, a method such as physical vapor deposition (PE-PVD), PE-CVD, or plating can be used. Next, the back surface rewire 154 is formed on the insulating layer 153, and the protective film 155 is formed on the back surface rewire 154. The back surface rewire 154 can be electrically connected to the through electrode 126.

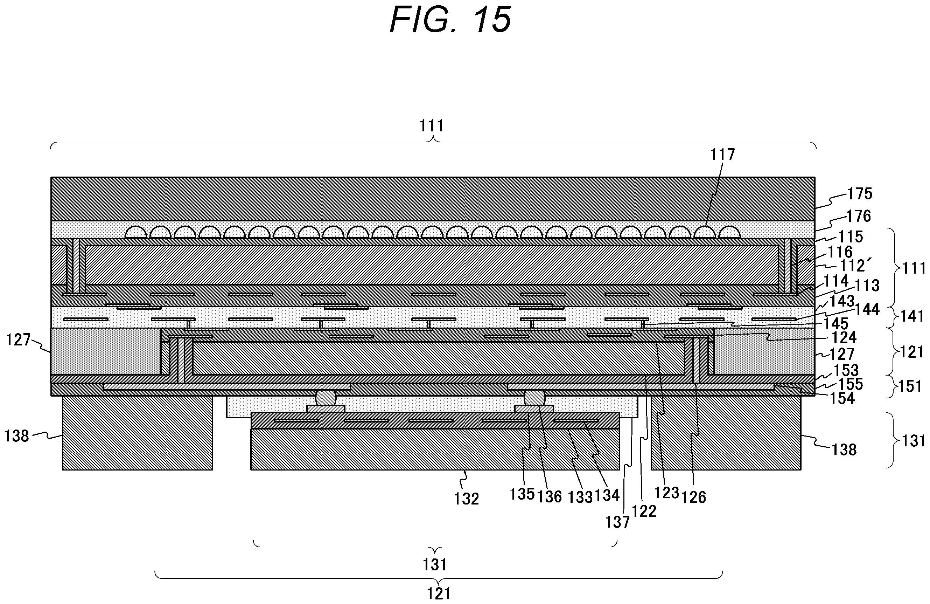

Next, as illustrated in Fig. 15, the chip 131 is flip-chip mounted on the extended back surface rewiring layer 151 via the bump electrode 136. At this time, the wiring layer 133 of the chip 131 can be electrically connected to the extended back surface rewiring layer 151. Next, the underfill 137 is filled between the extended back surface rewiring layer 151 and the chip 131. Furthermore, the dummy chip 138 is disposed around the chip 131 on the extended back surface rewiring layer 151. The dummy chip 138 may be bonded to the protective film 155 or may be bonded by using an adhesive layer.

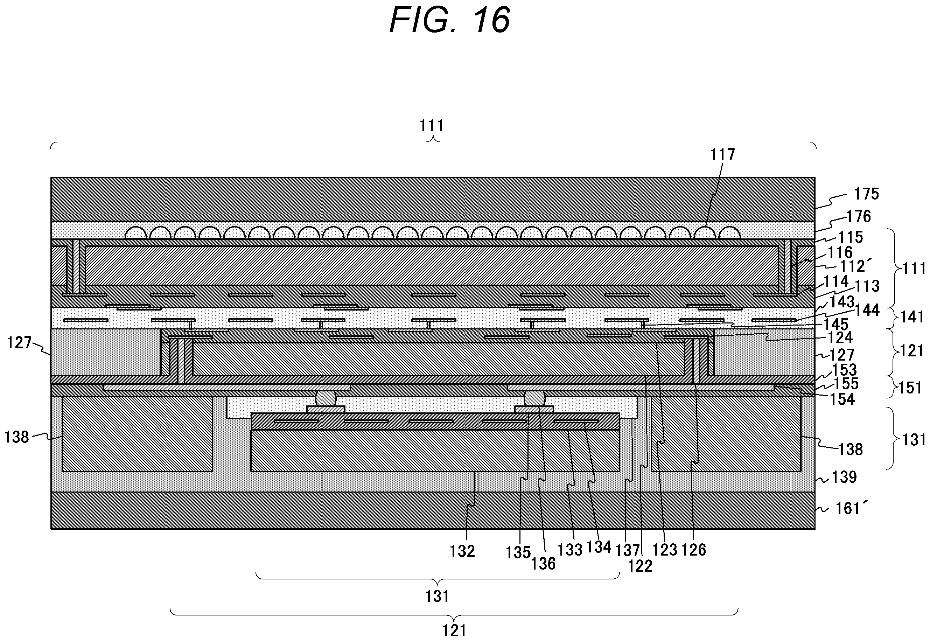

Next, as illustrated in Fig. 16, the protective film 139 is formed on the extended back surface rewiring layer 151 so as to cover the chip 131 and the dummy chip 138. In order to flatten the protective film 139, a front surface of the protective film 139 may be polished. Furthermore, a support substrate wafer 161' is bonded onto the protective film 139. The support substrate wafer 161' can have the same shape and size as the semiconductor wafer 112'.

Next, as illustrated in Fig. 1, the support substrate wafer 175 on the semiconductor wafer 112' is removed together with the adhesive layer 176. Then, by using a method such as dicing, a stacked wafer including the semiconductor wafer 112' on the support substrate wafer 161' is divided into solid pieces of a chip form to form the package 100. Thereafter, the bonding wire 118 is connected to the through electrode 116.

In this manner, in the first embodiment, the package 100 includes the extended rewiring layer 141 connected to the chip 121. Thus, the wire connected to the chip 121 can be led out from the position outside the wiring layer 123 of the chip 121. Therefore, even in a case where the chip 121 is smaller than the chip 111, the wire of the wiring layer 113 of the chip 111 can be electrically connected to the wire of the wiring layer 123 without extending the wire of the wiring layer 113 of the chip 121 to the position of the wiring layer 123. As a result, it is possible to increase a connection point between the wiring layer 113 of the chip 111 and the wiring layer 123 of the chip 121 while relaxing the restriction on a wiring layout of the wiring layer 113 of the chip 111 and the wiring layer 123 of the chip 121.

In addition, the package 100 includes the extended back surface rewiring layer 151 connected to the chip 121. Thus, the wire connected to the chip 121 can be led out from the back surface side outside the chip 121. Therefore, it is possible to increase a connection point between the wiring layer 123 of the chip 121 and the wiring layer 133 of the chip 131 while relaxing the restriction on a wiring layout of the wiring layer 123 of the chip 121 and the wiring layer 133 of the chip 131.

Furthermore, in the package 100, the positions of the ends in the lateral direction DL of the chip 111, the extended rewiring layer 141, the extended back surface rewiring layer 151, the protective films 127 and 139, and the support substrate 161 are equal to each other. Thus, the plurality of packages 100 can be collectively formed in a state where the plurality of packages 100 is integrated in a wafer shape, and then can be divided into solid pieces of individual packages 100, and a manufacturing efficiency of the package 100 can be improved.

Note that, in the first embodiment, a three-layer structure in which the three chips 111, 121, and 131 are stacked is taken as an example, but a two-layer structure in which two chips 111 and 121 are stacked or a two-layer structure in which two chips 121 and 131 are stacked may be used.

### <2. Second embodiment>

In the first embodiment, the through electrode 116 is provided on the uppermost-layer chip 111, and an external connection terminal is led out from an upper surface side of the package 100. In the second embodiment, a through electrode led out to a lower surface side of the package 100 is provided, and the external connection terminal is led out from the lower surface side of the package.

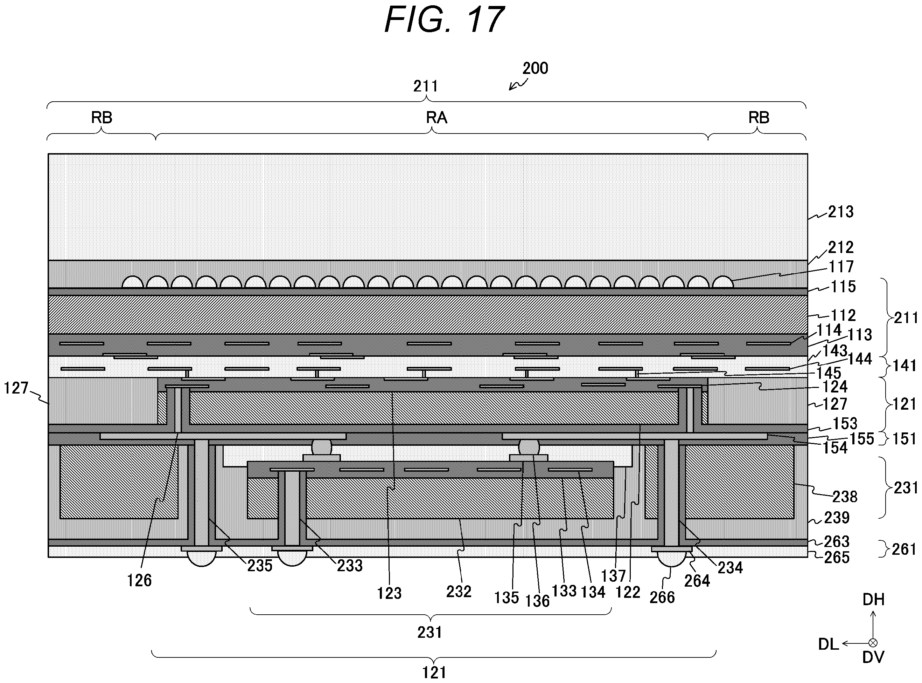

Fig. 17 is a sectional view illustrating a configuration example of a package according to a second embodiment.

In the drawing, the package 200 includes chips 211 and 231, a dummy chip 238, and a protective film 239 instead of the chips 111 and 131, the dummy chip 138, and the protective film 139 of the first embodiment. In addition, in the package 200, a transparent resin 212, a transparent substrate 213, through electrodes 233 to 235, and a rewiring layer 261 are added to the package 100 of the first embodiment. Other configurations of the package 200 of the second embodiment are similar to the configuration of the package 100 of the first embodiment.

The through electrode 116 of the first embodiment is omitted from the chip 211. Other configurations of the chip 211 are similar to the configurations of the chip 111 of the first embodiment.

On the back surface side of the semiconductor layer 112, a transparent resin 212 is formed so as to cover the on-chip lens 117. A transparent substrate 213 is disposed on the transparent resin 212. The material of the transparent resin 212 is, for example, silicone, acrylic, or polycarbonate. At this time, the refractive index of the transparent resin 212 can be made smaller than the refractive index of the on-chip lens 117. The material of the transparent substrate 213 may be, for example, quartz, glass, or Al₂O₃, CaF₂, MgF₂, LiF, or the like according to the wavelength of the optical element. The transparent resin 212 may be used as an adhesive layer for bonding the transparent substrate 213.

The chip 231 includes a semiconductor layer 232 instead of the semiconductor layer 132 of the first embodiment. The through electrode 233 is embedded in the semiconductor layer 232 via an insulating layer 263. The through electrode 233 is connected to the pad electrode 134 of the wiring layer 133.

The dummy chip 238 is mounted on the extended back surface rewiring layer 151 separately from the chip 231. A through electrode 234 is embedded in the dummy chip 238. The through electrode 234 is electrically connected to the back surface rewire 154 of the extended back surface rewiring layer 151.

The protective film 239 is formed on the extended back surface rewiring layer 151 so as to cover the chip 231 and the dummy chip 238. The through electrode 235 is embedded in the protective film 239 via the insulating layer 263. At this time, the through electrode 235 can be disposed at a position separated from the chip 231. The through electrode 235 is electrically connected to the back surface rewire 154 of the extended back surface rewiring layer 151.

The rewiring layer 261 includes an insulating layer 263, a land electrode 264, and a protective film 265. A rewire may be formed in the rewiring layer 261. The insulating layer 263 is formed on the protective film 239. At this time, the insulating layer 263 is formed on the semiconductor layer 232 and the protective film 239 so as to surround an outer periphery of the through electrode 233. In addition, the insulating layer 263 is formed on the dummy chip 238 and the protective film 239 so as to surround an outer periphery of the through electrode 234. In addition, the insulating layer 263 is formed on the protective film 239 so as to surround an outer periphery of the through electrode 235. The land electrode 264 is formed on the insulating layer 263. Each land electrode 264 is connected to the through electrodes 233, 234, and 235. A bump electrode 266 is formed on the land electrode 264.

Other configurations of the chip 231, the dummy chip 238, and the protective film 239 are similar to the configurations of the chip 131, the dummy chip 138, and the protective film 139 of the first embodiment.

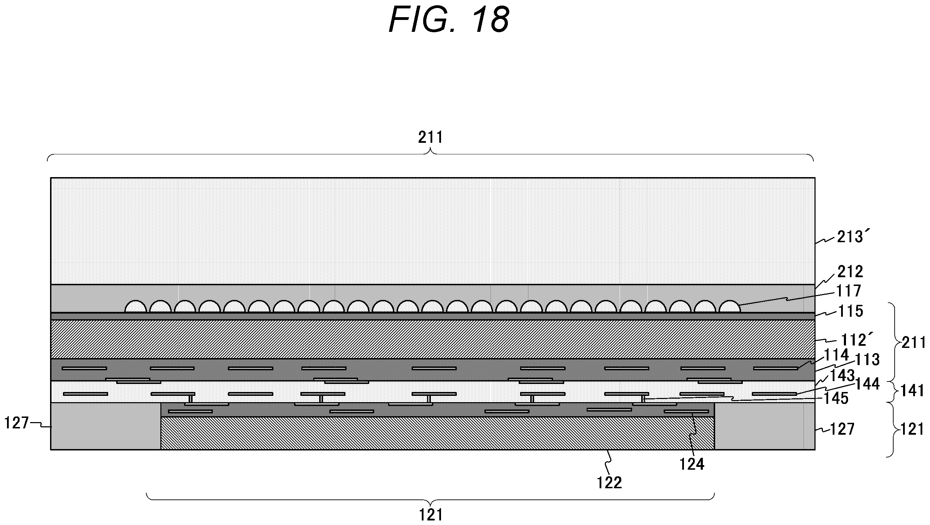

Figs. 18 to 22 are sectional views illustrating an example of a method for manufacturing a package according to the second embodiment.

Steps similar to the steps illustrated in Figs. 6 to 10 of the first embodiment are executed. Then, in the steps of Fig. 11 of the first embodiment, the formation of the through electrode 116 embedded in the semiconductor wafer 112' is omitted, and the on-chip lens 117 is formed on the protective film 115.

Next, as illustrated in Fig. 18, a transparent substrate wafer 213' is bonded to the semiconductor wafer 112' side via the transparent resin 212. The transparent substrate wafer 213' can have the same shape and size as the semiconductor wafer 112'.

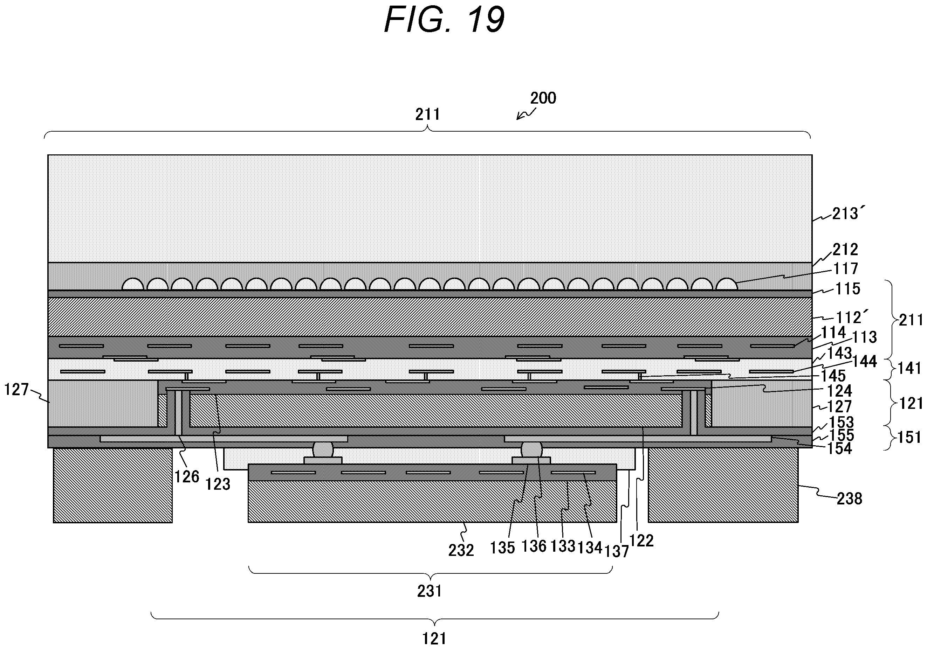

Next, as illustrated in Fig. 19, steps similar to the steps illustrated in Figs. 13 to 15 of the first embodiment are executed. At this time, instead of the chip 131 and the dummy chip 138, the chip 231 and the dummy chip 238 before formation of each of the through electrodes 233 and 234 are mounted on the extended back surface rewiring layer 151.

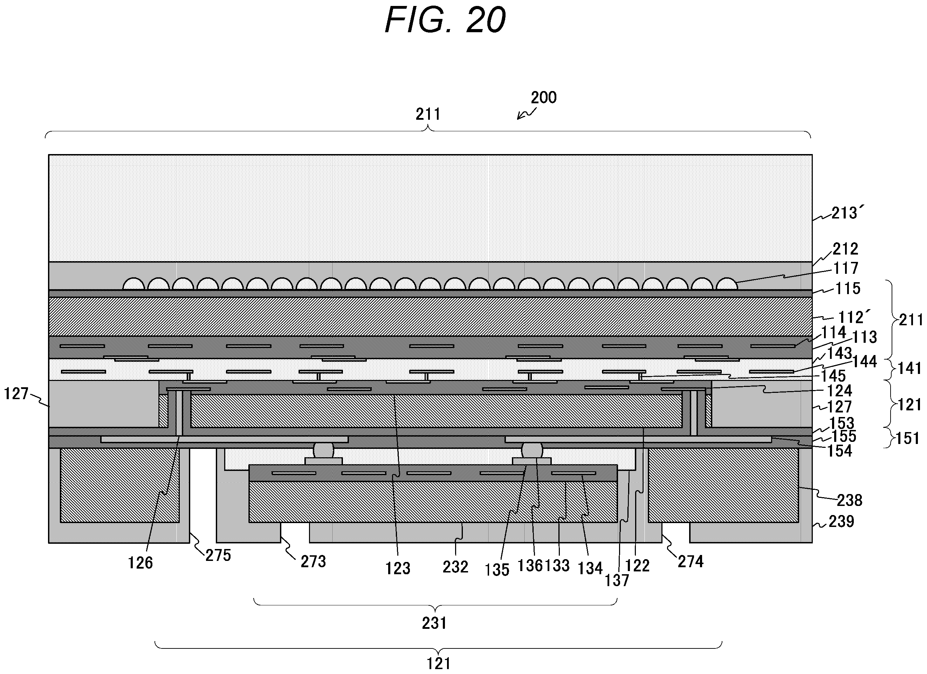

Next, as illustrated in Fig. 20, the protective film 239 is formed on the extended back surface rewiring layer 151 so as to cover the chip 231 and the dummy chip 238. In order to flatten the protective film 239, a front surface of the protective film 239 may be polished. Next, through holes 273 to 275 disposed at the embedded positions of the through electrodes 233 to 235 are each formed in the protective film 239. At this time, if the protective film 239 includes a photosensitive material, the through holes 273 to 275 are formed by lithography, and if the protective film 239 includes a non-photosensitive material, the through holes 273 to 275 are formed by lithography and dry etching.

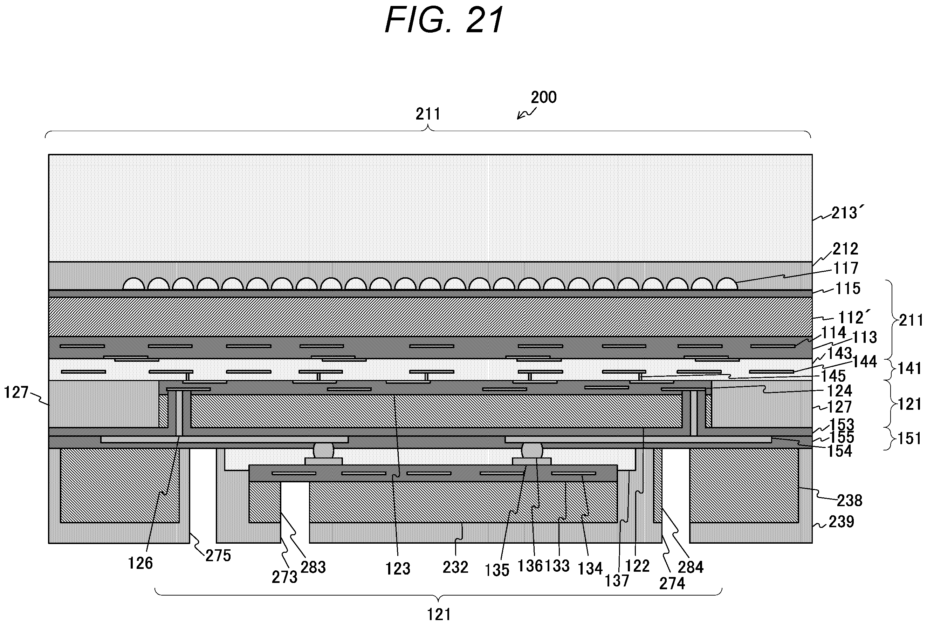

Next, as illustrated in Fig. 21, through holes 283 and 284 are formed in the semiconductor layer 232 and the dummy chip 238 by etching the semiconductor layer 232 and the dummy chip 238 by using the protective film 239 in which the through holes 273 to 275 are formed as an etching mask.

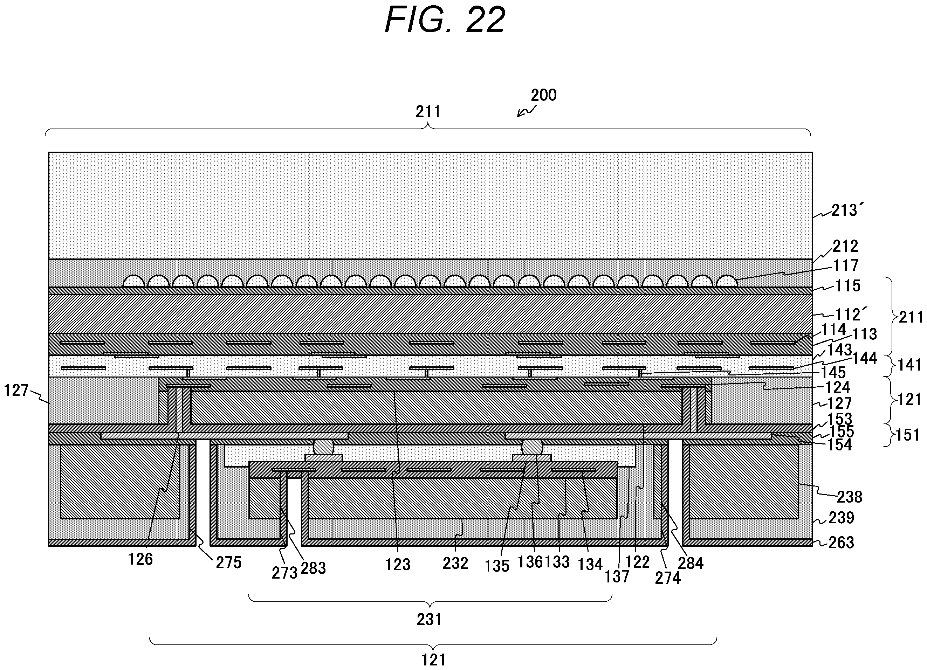

Next, as illustrated in Fig. 22, by using a method such as PE-CVD, the insulating layer 263 is formed on the protective film 239 so as to cover side walls of the through holes 273 to 275 and the through-holes 283 and 284. Furthermore, the pad electrode of the extended back surface rewiring layer 151 is exposed by dry etching the protective film 155 via the insulating layer 263.

Next, as illustrated in Fig. 17, the through electrodes 233 to 235 embedded in the through holes 273 to 275 and the through holes 283 and 284 via the insulating layer 263 are formed. For the formation of the through electrodes 233 to 235, for example, a method such as PE-PVD, PE-CVD, or plating can be used. Next, the rewire and the land electrode 264 are formed on the insulating layer 263, and the protective film 265 is formed on the rewire and the land electrode 264. Then, an opening through which the land electrode 264 is exposed is formed in the protective film 265, and the bump electrode 266 is formed on the land electrode 264 through the opening. Thereafter, by using a method such as dicing, a stacked wafer including the semiconductor wafer 112' on the transparent substrate wafer 213' is divided into solid pieces of a chip form to form the package 200.

In this manner, in the second embodiment, by providing the through electrodes 233 to 235 led out to a lower surface side of the package 200, a wiring path to the lowermost chip 231 can be made shorter than in the package 100 of the first embodiment. Therefore, IR drop and signal delay of the lowermost chip 231 can be reduced.

In addition, by providing the through electrodes 233 to 235 led out to the lower surface side of the package 200, it is possible to electrically connect to the outside from the lower surface side of the package 200. Since it is therefore not necessary to use wire bonding in order to electrically connect the package 200 to the outside, and a bonding region around the package 200 is not necessary, a mounting area of the package 200 can be reduced.

Furthermore, the through electrode 234 connected to the rewiring layer 261 is formed in the dummy chip 238 around the chip 231. Accordingly, even in a case where the size of the chip 211 is smaller than the size of the chip 231, it is possible to reduce the number of the through electrodes 233 formed on the chip 231 while uniformizing the heat dissipation and the internal stress of the package 200. Therefore, reliability of the package 200 can be improved, and a reduction of an element region of the chip 231 can be suppressed.

In addition, the through electrode 235 connected to the rewiring layer 261 is formed on the protective film 239 around the chip 231. As a result, even in a case where the size of the chip 211 is smaller than the size of the chip 231, it is possible to reduce the number of through electrodes 233 formed on the chip 231 while unifying the size and shape of a stacked surface of the chips to be three-dimensionally stacked. Therefore, the plurality of packages 200 can be integrally and collectively formed and then divided into solid pieces of individual packages 200, the manufacturing efficiency of the package 200 can be improved, and the reduction of the element region of the chip 231 can be suppressed.

### <3. Third embodiment>

In the second embodiment, the through electrodes 233 and 234 are provided in the chip 231 and the dummy chip 238, respectively, and the insulating layer 263 is provided in order to insulate the through electrodes 233 and 234 from the semiconductor layer 232 and the dummy chip 238, respectively. In a third embodiment, a through electrode connected to the extended back surface rewiring layer 151 is provided on the protective film 239, and the through electrodes 233 and 234 of the chip 231 and the dummy chip 238 and the insulating layer 263 are omitted.

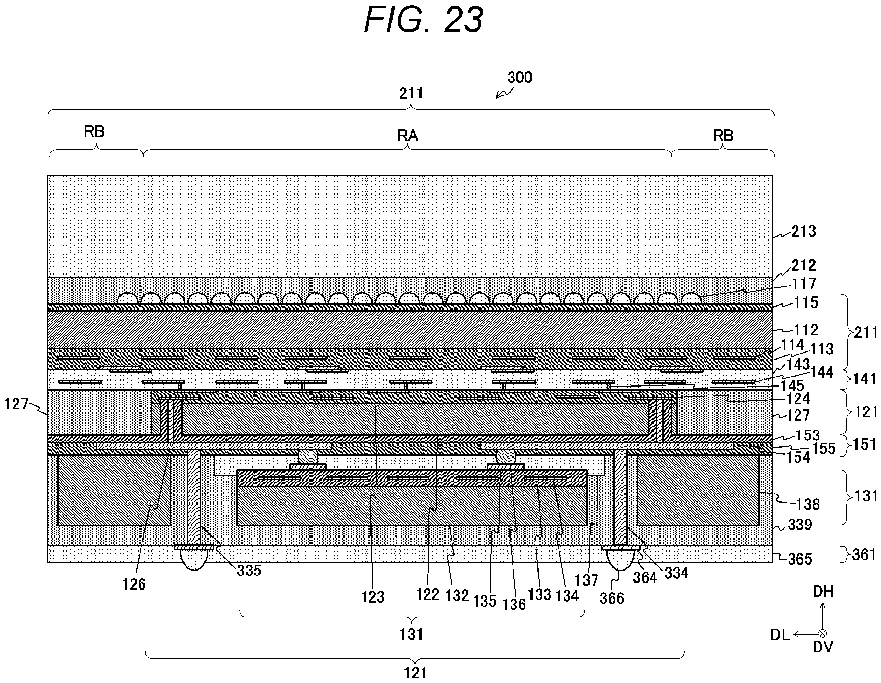

Fig. 23 is a sectional view illustrating a configuration example of a package according to the third embodiment.

In the drawing, a package 300 includes through electrodes 334 and 335, the chip 131, a dummy chip 138, and a protective film 339 instead of the through electrodes 233 to 235, the chip 231, the dummy chip 238, and the protective film 239 of the second embodiment. In addition, the package 300 includes a rewiring layer 361 instead of the rewiring layer 261 of the second embodiment. Furthermore, in the package 300, the insulating layer 263 of the second embodiment is omitted. Other configurations of the package 300 of the third embodiment are similar to the configuration of the package 200 of the second embodiment.

The protective film 339 is formed on the extended back surface rewiring layer 151 so as to cover the chip 131 and the dummy chip 138. The through electrodes 334 and 335 are embedded in the protective film 339. At this time, each of the through electrodes 334 and 335 can be in contact with the protective film 339. In addition, the through electrodes 334 and 335 can be disposed at a position separated from the chip 131. Each of the through electrodes 334 and 335 are electrically connected to the wire of the extended back surface rewiring layer 151.

The rewiring layer 361 includes a land electrode 364 and a protective film 365. A rewire may be formed in the rewiring layer 361. The land electrode 364 is formed on the protective film 339. At this time, each land electrode 364 can be disposed at a position in contact with each of the through electrodes 334 and 335. A bump electrode 366 is formed on the land electrode 364.

In this manner, in the third embodiment, the through electrodes 334 and 335 connected to the extended back surface rewiring layer 151 are formed on the protective film 365 around the chip 131. It is therefore possible to electrically connect the package 300 from a lower surface side to the outside without forming an insulating layer that insulates the through electrodes 334 and 335 on the protective film 365, and a mounting area of the package 300 can be reduced.

In addition, it is not necessary to form a through electrode on the chip 131 in order to lead out the external connection terminal from the lower surface side of the package 300. It is therefore not necessary to embed the through electrode in the semiconductor, a manufacturing step can be simplified, and an element region of the chip 131 can be increased.

### <4. Fourth embodiment>

In the first embodiment, the through electrode 126 connected to the extended rewiring layer 141 via the wiring layer 123 is provided in the chip 121. In a fourth embodiment, a through electrode connected to the extended rewiring layer 141 is provided in the protective film and the dummy chip around the chip 121.

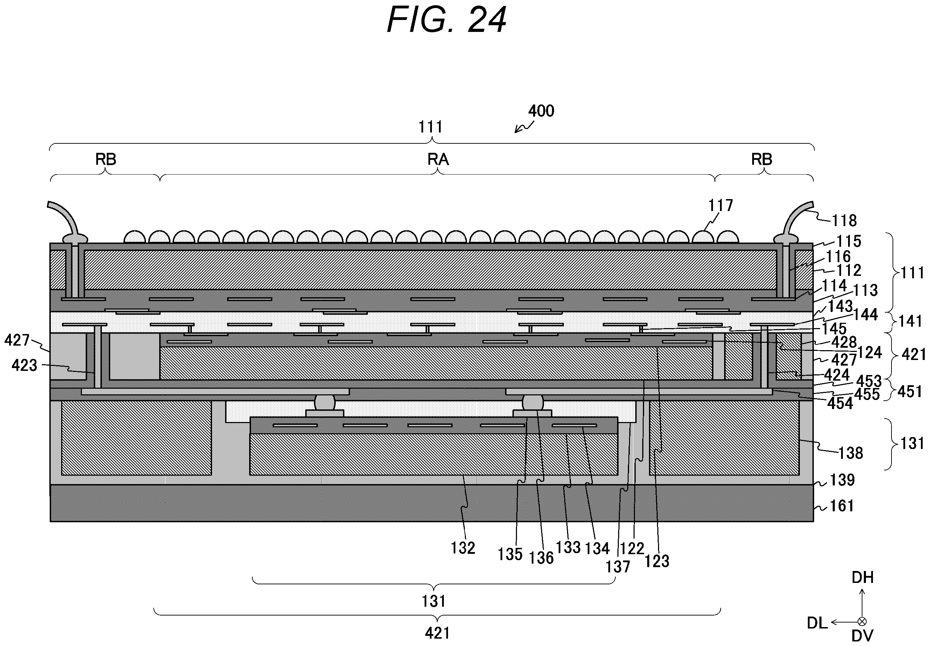

Fig. 24 is a sectional view illustrating a configuration example of a package according to the fourth embodiment.

In the drawing, the package 400 includes a chip 421, through electrodes 423 and 424, a protective film 427, and an extended back surface rewiring layer 451 instead of the chip 121, the through electrode 126, the protective film 127, and the extended back surface rewiring layer 151 of the first embodiment. In addition, in the package 400, a dummy chip 428 is added to the package 100 of the first embodiment. Other configurations of the package 400 of the fourth embodiment are similar to the configuration of the package 100 of the first embodiment.

The through electrode 126 of the first embodiment is omitted from the chip 421. The extended rewiring layer 141 is formed on a front surface side of the chip 421, and the extended back surface rewiring layer 451 is formed on a back surface side of the chip 421. Other configurations of the chip 421 are similar to the configurations of the chip 121 of the first embodiment.

The dummy chip 428 is disposed around the chip 421. At this time, the dummy chip 428 can be mounted on the extended rewiring layer 141 separately from the chip 421. The through electrode 424 is embedded in the dummy chip 428 via an insulating layer 453. The through electrode 424 is electrically connected to the rewire 144 of the extended rewiring layer 141. The dummy chip 428 can be fixed to the extended rewiring layer 141 via an adhesive layer. A front surface of the dummy chip 428 is flattened. The position of the flat surface of the dummy chip 428 in the height direction DH can be made substantially equal to the position of a top surface of the chip 421 in the height direction DH. The material of the dummy chip 428 may be a semiconductor such as Si or an inorganic material such as glass or ceramics. Note that the chip 421 may be disposed at a center of the dummy chip 428, or the dummy chip 428 may be disposed in a region including front, rear, left, and right ends. By arranging the dummy chip 428 on the extended rewiring layer 141, a mechanical strength and heat dissipation from the back surface of the package 400 can be improved. The dummy chip 428 is not required to be provided. Note that the dummy chip 428 is an example of the support member described in the claims.

The protective film 427 is formed in the lateral direction DL with respect to the chip 421. The protective film 427 can be in contact with a side surface of the chip 421. The through electrode 423 is embedded in the protective film 427. At this time, the through electrode 423 can be disposed at a position separated from the chip 421. The position of a front surface of the protective film 427 in the height direction DH can be made substantially equal to the position of the front surface of the chip 421 in the height direction DH. In addition, the position of a back surface of the protective film 427 in the height direction DH can be made substantially equal to the position of the back surface of the chip 421 in the height direction DH. The position of an end of the protective film 427 in the lateral direction DL can coincide with the position of an end of the chip 111 in the lateral direction DL.

The extended back surface rewiring layer 451 includes an insulating layer 453, a back surface rewire 454, and a protective film 455. The insulating layer 453 is formed on the back surface of the semiconductor layer 122, the protective film 427, and the dummy chip 428. At this time, the insulating layer 453 is formed in the protective film 427 so as to surround an outer periphery of the through electrode 423. In addition, the insulating layer 453 is formed in the dummy chip 428 so as to surround an outer periphery of the through electrode 424, and can insulate the through electrode 424 from the dummy chip 428. A back surface rewire 454 is formed on the insulating layer 453. The back surface rewire 454 can be connected to the through electrodes 423 and 424 and the bump electrode 136. The chip 131 is flip-chip mounted on the extended back surface rewiring layer 451 via the bump electrode 136. Note that the chip 131 may be directly bonded onto the extended back surface rewiring layer 451. In addition, the protective film 455 is formed on the insulating layer 453 so as to cover the back surface rewire 454. The sizes of a front surface of the extended back surface rewiring layer 451 may be equal to the size of the front surface of the chip 111.

In this manner, in the fourth embodiment, the through electrode 423 connected to the extended rewiring layer 141 is provided in the protective film 427 around the chip 121, and the through electrode 424 connected to the extended rewiring layer 141 is provided in the dummy chip 428 around the chip 121. Thus, it is not necessary to provide the chip 421 with the through electrode 126 formed on the chip 121 of the first embodiment, and the number of elements formed on the chip 421 can be increased.

Note that a through electrode may also be formed in the semiconductor layer 122 of the chip 421. At this time, the through electrode 423 formed in the protective film 427 and the through electrode formed in the semiconductor layer 122 of the chip 421 may be used separately for a power supply line and a signal line. In addition, the through electrode around the chip 421 may be formed only in the protective film 427 around the chip 421, or may be formed only in the dummy chip 428 around the chip 421.

In addition, a through electrode led out to a lower surface side of the package 400 may be provided to be electrically connected to the outside from the lower surface side of the package 400. For example, instead of the chips 111 and 131, the chips 211 and 231, the through electrodes 234 and 235, and the rewiring layer 261 of the second embodiment may be provided, and the support substrate 161 may be omitted. Alternatively, instead of the chip 111, the chip 211, the through electrodes 334 and 335, and the rewiring layer 361 of the third embodiment may be provided, and the support substrate 161 may be omitted.

### <5. Fifth embodiment>

In the first embodiment, the size of the uppermost-layer chip 111 is larger than the size of the lower chip 121, and the protective film 127 is provided around the chip 121. In a fifth embodiment, the size of the uppermost-layer chip is smaller than the size of the lower chip, and a protective film is provided around the uppermost chip.

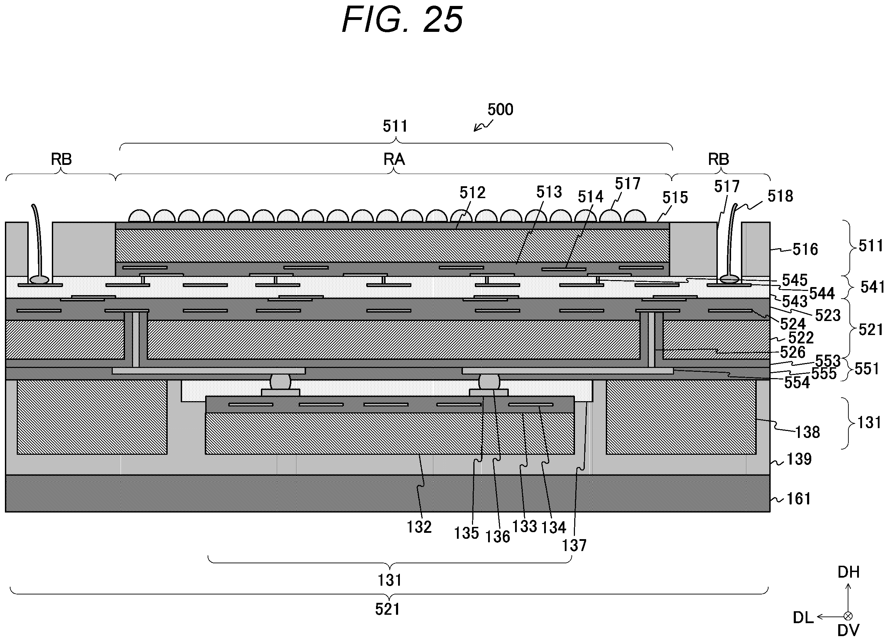

Fig. 25 is a sectional view illustrating a configuration example of a package according to the fifth embodiment.

In the drawing, a package 500 includes chips 511 and 521, an extended rewiring layer 541, and a back surface rewiring layer 551 instead of the chips 111 and 131, the extended rewiring layer 141, and the extended back surface rewiring layer 151 of the first embodiment. Other configurations of the package 500 of the fifth embodiment are similar to the configuration of the package 100 of the first embodiment.

The chip 511 is shorter in length at least in the lateral direction DL than the chip 521. As for a length in the vertical direction DV, the chip 511 may be shorter, longer, or equal to the chip 521.

The chips 511, 521, and 131 can constitute a three-layer stacked structure stacked in the height direction DH. At this time, the extended rewiring layer 541 is provided on a front surface side of the chip 511 and is extended from the chip 511 in the lateral direction DL. The back surface rewiring layer 551 is provided on a back surface side of the chip 521, and the length of the back surface rewiring layer 551 in the lateral direction DL is equal to the length of the chip 511 in the lateral direction DL. Then, the chips 511 and 521 are electrically connected to each other via the extended rewiring layer 541, and the chips 521 and 131 are electrically connected to each other via the back surface rewiring layer 551. Each of the chips 511 and 521 may be a semiconductor chip, and the chip 511 may be an optical chip.

In the following description, a case will be taken as an example where a back surface irradiation-type solid-state imaging element is formed on the chip 511, and a semiconductor element is formed on each of the chips 521 and 131.

The optical chip 511 includes a semiconductor layer 512 and a wiring layer 513. The semiconductor layer 512 is provided with an imaging region and a non-imaging region. A wiring layer 513 is formed on a front surface side of the semiconductor layer 512. The wiring layer 513 is provided with a wire and a pad electrode 514 embedded in an insulating layer. A protective film 515 is formed on the back surface side of the semiconductor layer 512. An on-chip lens 517 is formed on the protective film 515 for every pixel. In addition, a protective film 516 is formed in the lateral direction DL of the chip 511. The protective film 516 can be in contact with a side surface of the chip 511. The position of a front surface of the protective film 516 in the height direction DH can be made substantially equal to the position of the front surface of the chip 511 in the height direction DH. The position of an end of the protective film 516 in the lateral direction DL can coincide with the position of an end of the chip 521 in the lateral direction DL. A through hole 517 is formed in the protective film 516. At the position of the through hole 517, a pad electrode 544 is exposed from an insulating layer 543 of the extended rewiring layer 541. A bonding wire 518 is connected to the pad electrode 544 via the through hole 517 in order to be connected to the outside. Note that the bonding wire 518 is an example of an external connection terminal recited in claims.

The optical chip 521 includes a semiconductor layer 522 and a wiring layer 523. The wiring layer 523 is formed on the semiconductor layer 522. The wiring layer 523 is provided with a wire and a pad electrode 524 embedded in an insulating layer. In addition, a through electrode 526 is embedded in the semiconductor layer 522. The through electrode 526 is connected to the pad electrode 524 of the wiring layer 523.

The extended rewiring layer 541 is extended from the chip 511 in the lateral direction DL so as to be equal to the length of the chip 521 in the lateral direction DL. At this time, the position of an end of the extended rewiring layer 541 in the lateral direction DL and the position of the end of the chip 521 in the lateral direction DL can coincide with each other. The extended rewiring layer 541 is extended from a mounting region RA of the chip 511 to an extended region RB extended in the lateral direction DL.

The extended rewiring layer 541 includes the insulating layer 543 and a rewire and the pad electrode 544. The rewire and the pad electrode 544 are embedded in the insulating layer 543. In addition, a via 545 that performs interlayer connection of the rewire can be formed in the extended rewiring layer 541.

The chip 511 is disposed on one surface of the extended rewiring layer 541, and the protective film 516 is disposed in the extended region RB of the surface. The rewire of the extended rewiring layer 541 can be connected to the wire of the wiring layer 513 via the via 545. At this time, the extended rewiring layer 541 can be supported by the chip 511 and the protective film 516.

The chip 521 is disposed on the other surface of the extended rewiring layer 541. At this time, the chip 521 and the extended rewiring layer 541 may be directly bonded such that the wiring layer 523 of the chip 521 faces the extended rewiring layer 541.

The back surface rewiring layer 551 includes an insulating layer 553, a back surface rewire 554, and a protective film 555. The insulating layer 553 is formed on the back surface of the semiconductor layer 522. At this time, the insulating layer 553 is formed in the semiconductor layer 522 so as to surround an outer periphery of the through electrode 526, and can insulate the through electrode 526 from the semiconductor layer 522. The back surface rewire 554 is formed on the insulating layer 553. The back surface rewire 554 can be connected to the through electrode 526 and the bump electrode 136.

In this manner, in the fifth embodiment, the protective film 516 is provided around the uppermost-layer chip 511 connected to the extended rewiring layer 541. Thus, even in a case where the size of the uppermost-layer chip 511 is smaller than the size of the lower chip 521, the size of a stacked surface of the uppermost-layer chip 511 of the package 500 can be unified to the size of the lower chip 521. Therefore, the plurality of packages 500 can be integrally and collectively formed in a wafer shape and then divided into solid pieces of individual packages 500, the manufacturing efficiency of the package 500 can be improved.

Note that a plurality of chips may be disposed in the uppermost layer. In addition, a through electrode led out to a lower surface side of the package 500 may be provided to be electrically connected to the outside from the lower surface side of the package 500.

### <6. Sixth embodiment>

In the first embodiment, the extended rewiring layer 141 extended from the intermediate-layer chip 121 in the lateral direction DL is provided and connected to the uppermost-layer chip 111. In a sixth embodiment, an extended rewiring layer extended from the lowermost-layer chip in the lateral direction DL is provided and connected to the intermediate-layer chip.

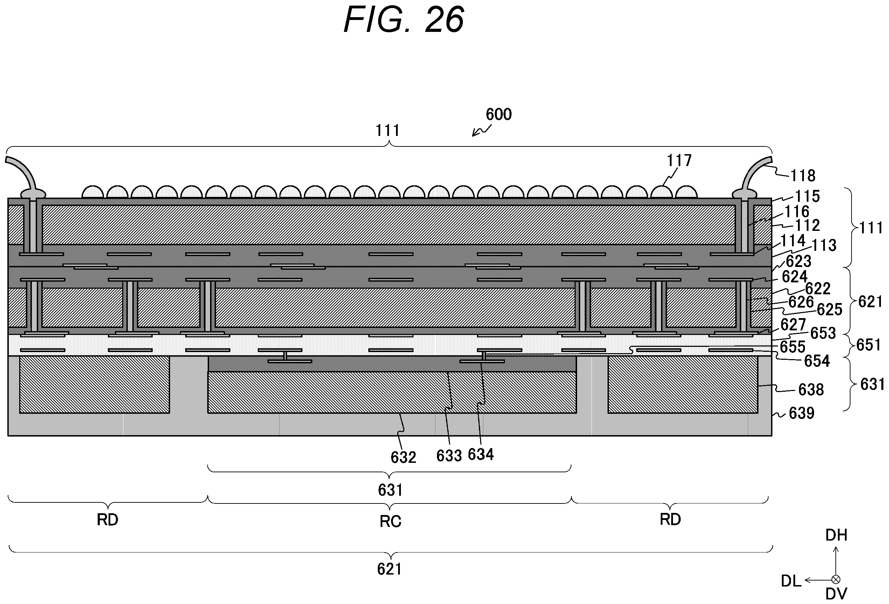

Fig. 26 is a sectional view illustrating a configuration example of a package according to the sixth embodiment.

In the drawing, a package 600 includes chips 621 and 631 and an extended rewiring layer 651 instead of the chips 111 and 131 and the extended rewiring layer 141 of the first embodiment. In addition, in the package 600, the extended back surface rewiring layer 151, the underfill 137, and the support substrate 161 of the first embodiment are omitted. Other configurations of the package 600 of the sixth embodiment are similar to the configuration of the package 100 of the first embodiment.

Each of the chips 111 and 621 has an equal length at least in the lateral direction DL. At this time, the position of an end of the chip 621 in the lateral direction DL can be made equal to the position of the end of the chip 111 in the lateral direction DL. The chip 631 is shorter in length at least in the lateral direction DL than the chip 111. The extended rewiring layer 651 is provided on a front surface of the chip 631 and is extended from the chip 631 in the lateral direction DL. Then, the chips 111 and 621 are electrically connected to each other on the basis of direct bonding, and the chips 621 and 631 are electrically connected to each other via the extended rewiring layer 651.

The chip 621 includes a semiconductor layer 622 and a wiring layer 623. The wiring layer 623 is formed on the semiconductor layer 622. The wiring layer 623 is provided with a wire and a pad electrode 624 embedded in an insulating layer. In addition, a through electrode 626 is embedded in the semiconductor layer 622. The through electrode 626 is connected to the pad electrode 624 of the wiring layer 623. An insulating layer 625 is formed on a back surface side of the semiconductor layer 622. The insulating layer 625 is formed in the semiconductor layer 622 so as to surround an outer periphery of the through electrode 626, and can insulate the through electrode 626 from the semiconductor layer 622. A back surface wire and a pad electrode 627 are formed on the insulating layer 625. The pad electrode 627 is connected to the through electrode 626.

The chip 631 includes a semiconductor layer 632 and a wiring layer 633. The wiring layer 633 is formed on the semiconductor layer 632. The wiring layer 633 is provided with a wire 634 buried in the insulating layer.

The extended rewiring layer 651 is extended from the chip 631 in the lateral direction DL so as to be equal to the length of the chip 111 in the lateral direction DL. At this time, the position of an end of the extended rewiring layer 651 in the lateral direction DL and the position of the end of the chip 111 in the lateral direction DL can coincide with each other. The extended rewiring layer 651 is extended from a mounting region RC of the chip 631 to an extended region RD extended in the lateral direction DL.

The extended rewiring layer 651 includes an insulating layer 653 and a rewire 654. The rewire 654 is embedded in the insulating layer 653. In addition, a via 655 that performs interlayer connection of the rewire 654 can be formed in the extended rewiring layer 651.

The chip 621 is disposed on one surface of the extended rewiring layer 651. At this time, the chip 621 and the extended rewiring layer 651 may be directly bonded such that the back surface wire of the chip 621 and the pad electrode 627 face the extended rewiring layer 651.

The chip 631 is disposed on the other surface of the extended rewiring layer 141, and a dummy chip 638 and a protective film 639 are disposed in the extended region RD on the other surface. The rewire 654 of the extended rewiring layer 651 can be connected to the wire 634 of the wiring layer 633 via the via 655. At this time, the extended rewiring layer 651 can be supported by the chip 631, the dummy chip 638, and the protective film 639.

The dummy chip 638 can be mounted on the extended rewiring layer 651 separately from the chip 631. The dummy chip 638 can be fixed to the extended rewiring layer 651 via an adhesive layer. A front surface of the dummy chip 638 is flattened. The position of the flat surface of the dummy chip 638 in the height direction DH can be made substantially equal to the position of a top surface of the chip 631 in the height direction DH.

The protective film 639 is formed on the extended rewiring layer 651 so as to cover the chip 631 and the dummy chip 638. The position of an end of the protective film 639 in the lateral direction DL can coincide with the position of the end of the chip 111 in the lateral direction DL.

In this manner, in the sixth embodiment, the package 600 includes the extended rewiring layer 651 connected to the chip 631. Thus, the wire connected to the chip 631 can be led out from the position outside the wiring layer 633 of the chip 631. Therefore, even in a case where the chip 631 is smaller than the chip 621, a back surface wire of the chip 621 can be electrically connected to the wire 634 of the wiring layer 633 of the chip 631 without extending the back surface wire of the chip 621 to the position of the wiring layer 633 of the chip 631. As a result, it is possible to increase a connection point between the back surface wire of the chip 621 and the wire 634 of the chip 631 while relaxing the restriction on a layout of the back surface wire of the chip 621 and the wire 634 of the chip 631.

Furthermore, in the package 600, the positions of the ends in the lateral direction DL of the chips 111 and 621, the extended rewiring layer 651, and the protective film 639 are equal to each other. Thus, the plurality of packages 600 can be collectively formed in a state where the plurality of packages 600 is integrated in a wafer shape, and then can be divided into solid pieces of individual packages 600, and a manufacturing efficiency of the package 600 can be improved.

Note that a support substrate bonded to the protective film 639 may be stacked, or a plurality of chips may be disposed in the lowermost layer. In addition, a through electrode led out to a lower surface side of the package 600 may be provided to be electrically connected to the outside from the lower surface side of the package 600. For example, instead of the chips 111 and 631, the chips 211 and 231, the through electrodes 234 and 235, the extended rewiring layer 141, the extended back surface rewiring layer 151, and the rewiring layer 261 of the second embodiment may be provided. Alternatively, instead of the chip 111 and the protective film 639, the chip 211, the through electrodes 334 and 335, the extended rewiring layer 141, the extended back surface rewiring layer 151, and the rewiring layer 261 of the third embodiment and the protective film 639 may be provided. Alternatively, instead of the chip 621, the chip 421, the protective film 427, the dummy chip 428, the through electrodes 423 and 424, the extended rewiring layer 141, and the extended back surface rewiring layer 451 of the fourth embodiment may be provided. Alternatively, instead of the chip 111, the chip 511, the extended rewiring layer 541, and the protective film 516 of the fifth embodiment may be provided.

### <7. Seventh embodiment>

In the first embodiment, a three-layer stacked structure of the chips 111, 121, and 131 is formed by using the extended rewiring layer 141 and the extended back surface rewiring layer 151. In a seventh embodiment, a five-layer stacked structure of a chip is formed by using an extended rewiring layer and an extended back surface rewiring layer.

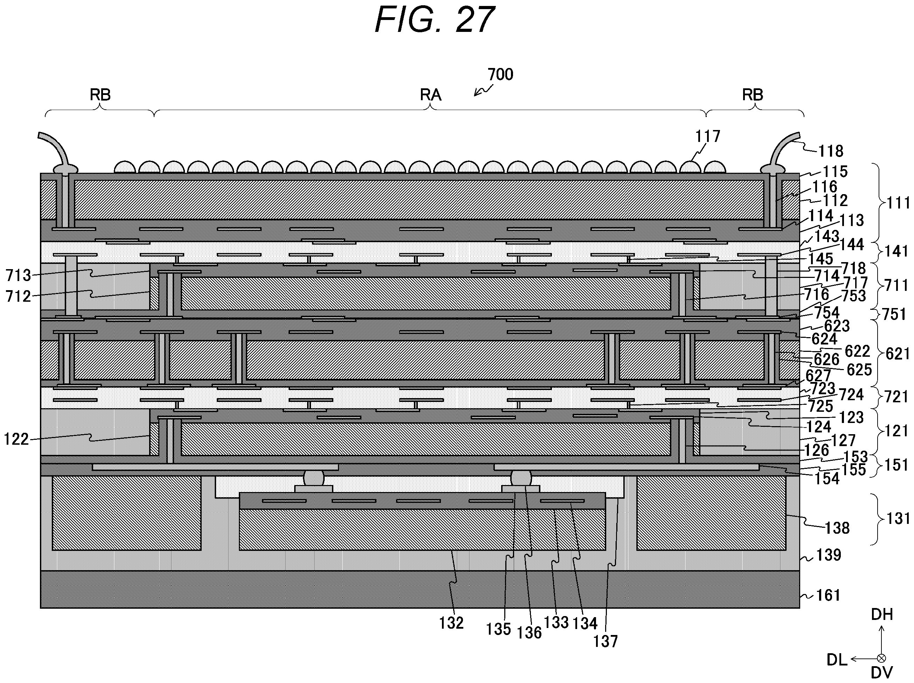

Fig. 27 is a sectional view illustrating a configuration example of a package according to the seventh embodiment.

In the drawing, in the package 700, a chip 711, an extended rewiring layer 721, and an extended back surface rewiring layer 751 are added to the package 100 of the first embodiment. The chip 711 is shorter in length at least in the lateral direction DL than the chip 111. In addition, in the package 700, the chip 621 of the sixth embodiment is added to the package 100 of the first embodiment.

The chips 111, 121, 131, 621, and 711 can constitute a five-layer stacked structure stacked in the height direction DH. At this time, the extended rewiring layer 721 is provided on the front surface side of the chip 121 and is extended from the chip 121 in the lateral direction DL. The extended back surface rewiring layer 751 is provided on a back surface side of the chip 711 and is extended from the chip 711 in the lateral direction DL. Then, the chips 111 and 711 are electrically connected to each other via the extended rewiring layer 141, and the chips 711 and 621 are electrically connected to each other via the extended back surface rewiring layer 751. Furthermore, the chips 621 and 121 are electrically connected to each other via the extended rewiring layer 721.

The chip 711 includes a semiconductor layer 712 and a wiring layer 713. The wiring layer 713 is formed on the semiconductor layer 712. The wiring layer 713 is provided with a wire and a pad electrode 714 embedded in an insulating layer. In addition, a through electrode 716 is embedded in the semiconductor layer 712. The through electrode 716 is connected to the pad electrode 714 of the wiring layer 713.

The extended rewiring layer 721 is extended from the chip 121 in the lateral direction DL so as to be equal to the length of the chip 111 in the lateral direction DL. At this time, the position of an end of the extended rewiring layer 721 in the lateral direction DL and the position of the end of the chip 111 in the lateral direction DL can coincide with each other. The extended rewiring layer 721 is extended from a mounting region RA of the chip 121 to an extended region RB extended in the lateral direction DL.

The extended rewiring layer 721 includes an insulating layer 723 and a rewire 724. The rewire 724 is embedded in the insulating layer 723. In addition, a via 725 that performs interlayer connection of the rewire 724 can be formed in the extended rewiring layer 721.

The chip 621 is disposed on one surface of the extended rewiring layer 721. At this time, the chip 621 and the extended rewiring layer 721 may be directly bonded such that the back surface wire of the chip 621 and the pad electrode 627 face the extended rewiring layer 721.

The chip 121 is disposed on the other surface of the extended rewiring layer 721, and the protective film 127 is disposed in the extended region RB of the surface. The rewire 724 of the extended rewiring layer 721 can be connected to the wire of the wiring layer 123 via the via 725. At this time, the extended rewiring layer 721 can be supported by the chip 121 and the protective film 127.

The extended back surface rewiring layer 751 is extended from the chip 711 in the lateral direction DL so as to be equal to the length of the chip 111 in the lateral direction DL. At this time, the position of an end of the extended back surface rewiring layer 751 in the lateral direction DL and the position of the end of the chip 111 in the lateral direction DL can coincide with each other. The extended back surface rewiring layer 751 is extended from the mounting region RA of the chip 121 to the extended region RB extended in the lateral direction DL.

The extended back surface rewiring layer 751 includes an insulating layer 753 and a back surface rewire 754. The insulating layer 753 is formed on the back surface of the semiconductor layer 712 and a protective film 717. At this time, the insulating layer 753 is formed in the semiconductor layer 712 so as to surround an outer periphery of the through electrode 716, and can insulate the through electrode 716 from the semiconductor layer 712. The back surface rewire 754 is formed on the insulating layer 753. The back surface rewire 753 can be directly bonded to the wiring layer 623 of the chip 621.

The protective film 717 is formed in the lateral direction DL of the chip 711. The protective film 717 can be in contact with a side surface of the chip 711. The position of a front surface of the protective film 717 in the height direction DH can be made substantially equal to the position of the front surface of the chip 711 in the height direction DH. The position of an end of the protective film 717 in the lateral direction DL can coincide with the position of an end of the chip 111 in the lateral direction DL.

The through electrode 718 is embedded in the protective film 717. At this time, the through electrode 718 can be disposed at a position separated from the chip 711. One end of the through electrode 718 is electrically connected to the rewire 144 of the extended rewiring layer 141, and the other end of the through electrode 718 is electrically connected to the back surface rewire 754 of the extended back surface rewiring layer 751.

In this manner, in the seventh embodiment, the extended rewiring layers 141 and 721 and the extended back surface rewiring layers 151 and 751 are used to form a five-layer stacked structure of the chips 111, 121, 131, 621, and 711. Thus, it is possible to increase the number of input and output terminals that can be disposed between chips while coping with an increase in the number of stacked chips having different chip sizes, and it is possible to unify the size and shape of the stacked surfaces of the chips to be three-dimensionally stacked. It is therefore possible to increase the number of stacked chips while suppressing an increase in manufacturing steps, and it is possible to achieve high integration of elements mounted on the package while suppressing an increase in package size.

For example, the number of packages to be divided into solid pieces from one wafer is M (M is an integer of two or more), and the number of stacked chips mounted on the package is N (N is an integer of two or more). At this time, in a method of stacking the chips divided into solid pieces, M×(N-1) times of stacking steps are required to manufacture M packages. On the other hand, in a method of stacking chips in a wafer state before the chips are divided into solid pieces, (N-1) times of stacking steps are sufficient, and the stacking step can be reduced to 1/M.

Note that a through electrode led out to a lower surface side of the package 700 may be provided to be electrically connected to the outside from the lower surface side of the package 700. For example, instead of the chips 111 and 131, the chips 221 and 232, the through electrodes 234 and 235, the extended rewiring layer 141, and the extended back surface rewiring layer 151 of the second embodiment may be provided.

In addition, in the above embodiments, a three-layer structure using one extended rewiring layer and one extended back surface rewiring layer and a five-layer structure using two extended rewiring layers and two extended back surface rewiring layers have been described. The present invention is not limited to the three-layer structure and the five-layer structure, and the number of stacked chips is not limited as long as the stacked structure has two or more layers. At this time, by increasing the number of extended rewiring layers and the number of extended back surface rewiring layers used in one package, it is possible to increase the number of stacked chips while unifying the size and shape of the stacked surface of the three-dimensionally stacked chips.

In addition, in the package in which the stacked structure of two or more layers of chips is formed, it is sufficient that there is at least one chip having an equal length to the length in the lateral direction DL of the package and there is at least one chip shorter than the length in the lateral direction DL of the package. In addition, a stacking position of the chips equal to the length of the package in the lateral direction DL is not limited, and may be in any layer.

### <8. Eighth embodiment>

In the sixth embodiment, in order to electrically connect the upper-layer chip 111 and the lower-layer chip 631 via the intermediate-layer chip 621, the back surface wire is provided on a back surface side of the chip 621 provided with the through electrode 626. In the eighth embodiment, in order to electrically connect the upper-layer chip 111 and the lower-layer chip 631 via the intermediate-layer chip, the through electrode penetrating the intermediate-layer chip is bonded to the pad electrode 114 of the wiring layer 113 of the upper-layer chip 111.

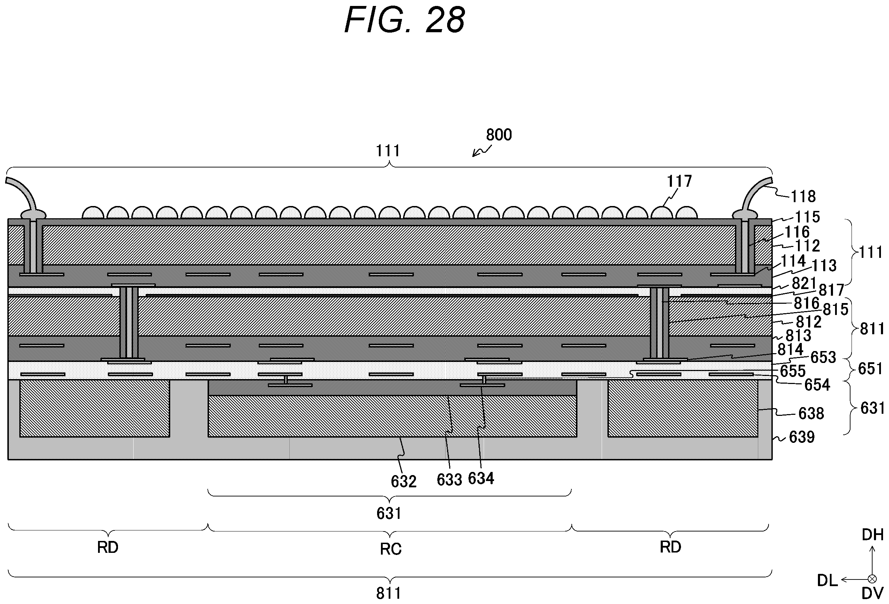

Fig. 28 is a sectional view illustrating a configuration example of a package according to the eighth embodiment.

In the drawing, a package 800 includes a chip 811 instead of the chip 621 of the sixth embodiment. In addition, in the package 800, an adhesive layer 821 and a light shielding layer 817 are added to the package of the sixth embodiment. Other configurations of the package 800 of the eighth embodiment are similar to the configuration of the package 600 of the sixth embodiment.

The length of the chip 811 in the lateral direction DL is equal to the length of the chip 111 in the lateral direction DL. At this time, the position of an end of the chip 811 in the lateral direction DL can be made equal to the position of the end of the chip 111 in the lateral direction DL. A back surface side of the chip 811 is bonded to the chip 111 via the adhesive layer 821. A front surface side of the chip 811 is electrically connected to the extended rewiring layer 651 on the basis of direct bonding.

The chip 811 includes a semiconductor layer 812 and a wiring layer 813. The wiring layer 813 is formed on the semiconductor layer 812. The wiring layer 813 is provided with a wire and a pad electrode 814 embedded in an insulating layer. The wiring layer 813 is directly bonded to the extended rewiring layer 651. At this time, the wire of the wiring layer 813 and the pad electrode 814 are electrically connected to the back surface wire 654 of the extended rewiring layer 651. In addition, a through electrode 816 is embedded in the semiconductor layer 812. The through electrode 816 penetrates the adhesive layer 821 and is connected to the pad electrode of the wiring layer 113. In addition, the through electrode 816 penetrates the insulating layer of the wiring layer 813 and is connected to the pad electrode 814 of the wiring layer 813. In the semiconductor layer 812, an insulating layer 815 is formed so as to surround an outer periphery of the through electrode 816. The insulating layer 815 may penetrate the adhesive layer 821 and reach the pad electrode 114 of the wiring layer 113, or may penetrate the insulating layer of the wiring layer 813 and reach the pad electrode 814 of the wiring layer 813.

The adhesive layer 821 bonds the chips 111 and 811 to each other. The material of the adhesive layer 821 may be a resin adhesive layer, an inorganic film such as SiO₂, SiON, SiN, SiOC, or SiCN, or a stacked layers of the above.

The light shielding layer 817 shields light incident on the chip 111 from a surface opposite to a light receiving surface of the chip 111. The light shielding layer 817 may be formed on an entire back surface of the semiconductor layer 812 except for a penetrating position of the through electrode 816. The light shielding layer 817 may be formed in the adhesive layer 821 or may be formed at an interface between the chip 111 and the adhesive layer 821. The material of the light shielding layer 817 may be, for example, black resin, or metal such as Cr, Al, or Cu.

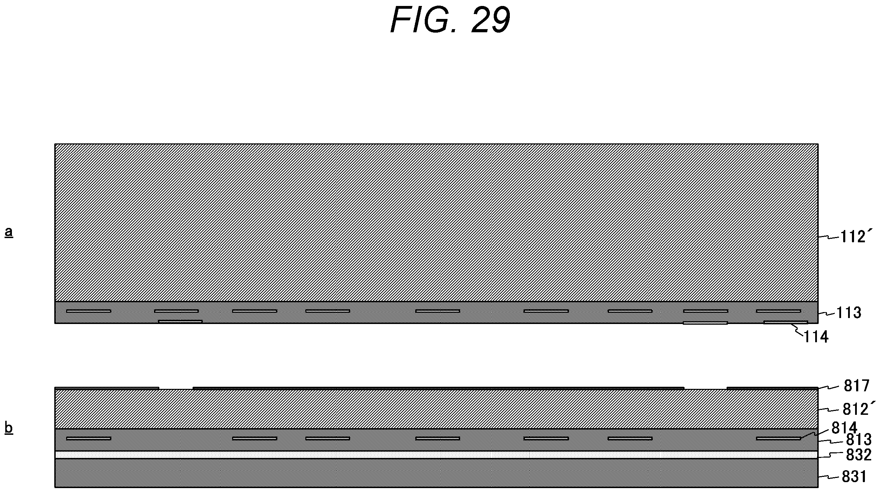

Figs. 29 to 35 are sectional views illustrating an example of a method for manufacturing a package according to the eighth embodiment.

In a of Fig. 29, the wiring layer 113 provided with the wire and the pad electrodes 114 is formed on a semiconductor wafer 112'. A plurality of chips 111 used for a plurality of packages 800 can be cut out from the semiconductor wafer 112'. At this time, the semiconductor wafer 112' may be sectioned along dicing lines used to divide the package 800 into solid pieces.

In addition, in b of Fig. 29, the wiring layer 813 provided with the wire and the pad electrodes 814 is formed on a semiconductor wafer 812'. A plurality of chips 811 used for a plurality of packages 800 can be cut out from the semiconductor wafer 812'. At this time, the semiconductor wafer 812' may be sectioned along dicing lines used to divide the package 800 into solid pieces.

Next, the wiring layer 813 on the semiconductor wafer 812' is temporarily bonded to a support substrate wafer 831 via an adhesive layer 832. Then, the semiconductor wafer 812' is thinned from a back surface side by a method such as CMP. Thereafter, the light shielding layer 817 is formed on the back surface side of the semiconductor wafer 812'. Note that the light shielding layer 817 may be patterned such that the light shielding layer 817 is removed at the penetrating position of the through electrode 816.

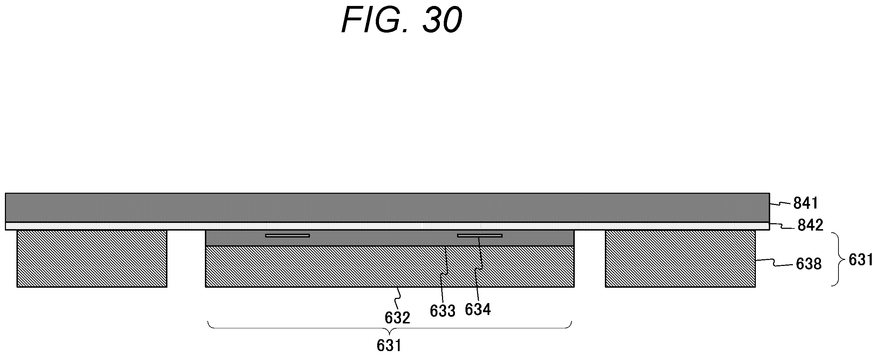

Next, as illustrated in Fig. 30, the chip 631 and the dummy chip 638 are temporarily bonded to a support substrate wafer 841 via an adhesive layer 842. A plurality of chips 631 used for the plurality of packages 800 can be temporarily bonded onto the support substrate wafer 841. At this time, the support substrate wafer 841 may be sectioned along dicing lines used to divide the package 800 into solid pieces.

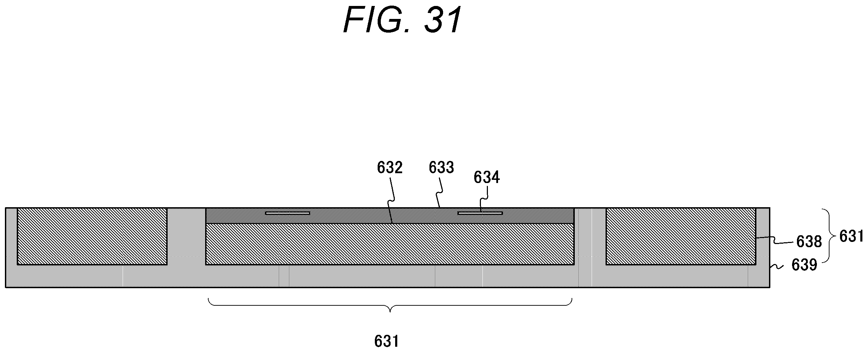

Next, as illustrated in Fig. 31, the protective film 639 is formed on the support substrate wafer 841 so as to cover the chip 631 and the dummy chip 638. In order to flatten the protective film 639, a front surface of the protective film 639 may be polished. Next, the support substrate wafer 841 and the adhesive layer 842 are removed.

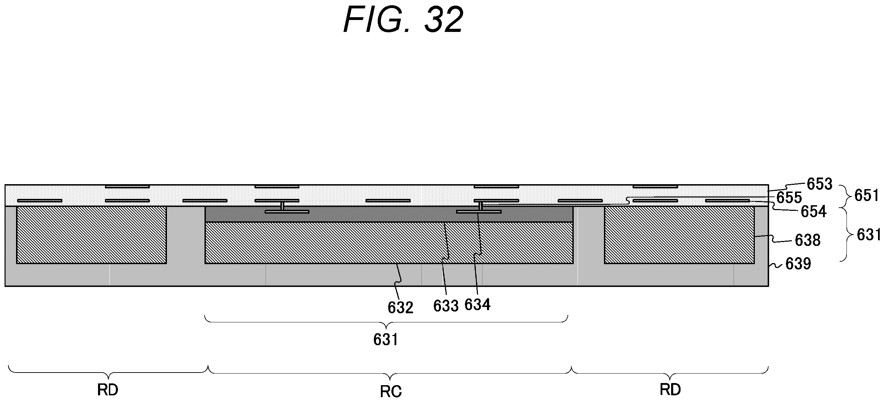

Next, as illustrated in Fig. 32, the extended rewiring layer 651 electrically connected to the wiring layer 633 of the chip 631 is formed on the chip 631, the dummy chip 638, and the protective film 639. At this time, the extended rewiring layer 651 is extended from the mounting region RC of the chip 631 to the extended region RD.

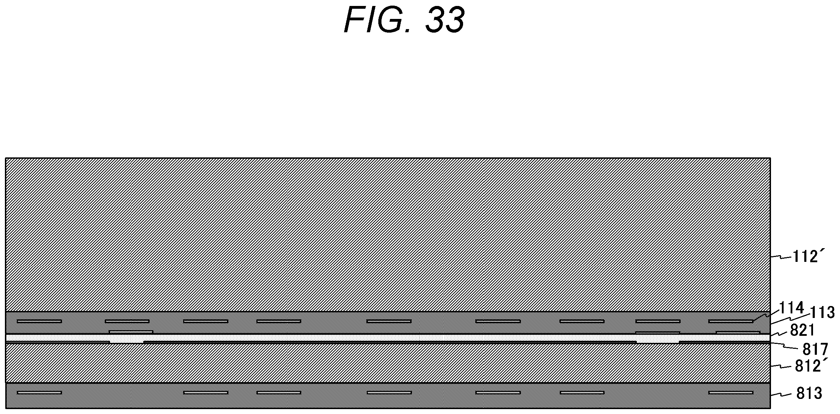

Next, as illustrated in Fig. 33, the wiring layer 113 on the semiconductor wafer 112' is bonded to the back surface side of the semiconductor wafer 812' via the adhesive layer 821.

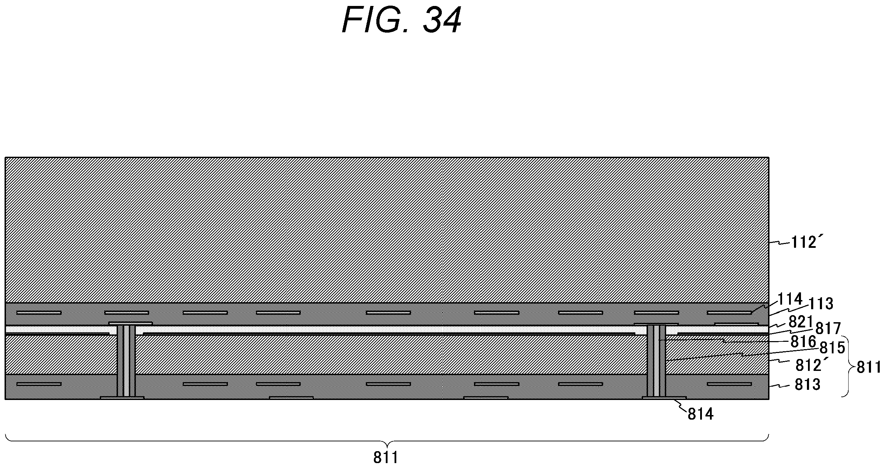

Next, as illustrated in Fig. 34, the insulating layer 815 is formed. The insulating layer 815 penetrates the insulating layer of the wiring layer 813, the semiconductor wafer 812', and the adhesive layer 821 and covers side walls of the insulating layer of the wiring layer 813, the semiconductor wafer 812', and the adhesive layer 821. Then, the through electrode 816 which is embedded in the insulating layer of the wiring layer 813, the semiconductor wafer 812', and the adhesive layer 821 via the insulating layer 815 is formed. Thereafter, the pad electrode 814 connected to the through electrode 816 is formed on a front surface side of the wiring layer 813. At this time, the pad electrode 814 is exposed to the front surface side of the wiring layer 813.

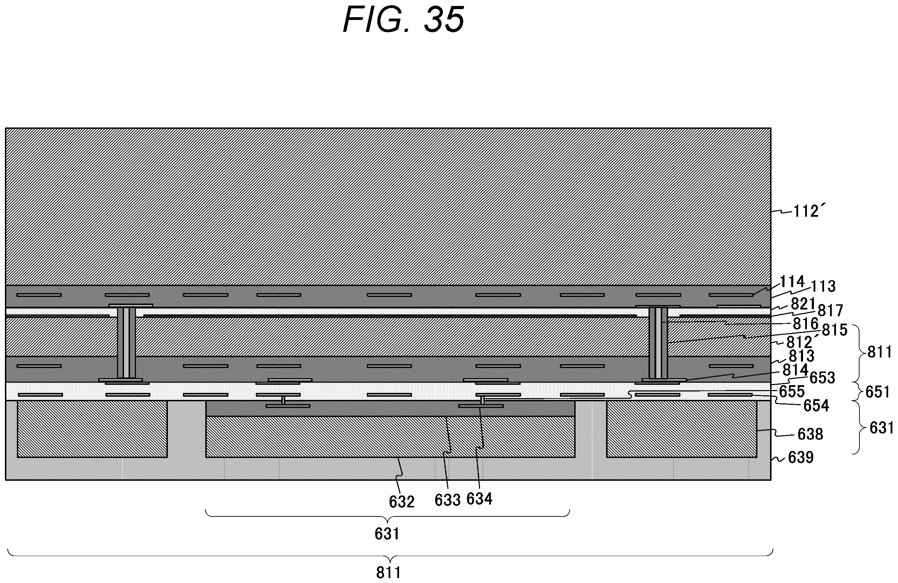

Next, as illustrated in Fig. 35, the wiring layer 813 on the semiconductor wafer 812' is directly bonded to the extended rewiring layer 651. At this time, the pad electrode 814 is electrically connected to the rewire 654 of the extended rewiring layer 651.

Next, as illustrated in Fig. 28, the semiconductor wafer 112' is thinned from the back surface side by a method such as CMP. Then, a through hole in which the through electrode 116 is embedded is formed in the semiconductor wafer 112', and the pad electrode 114 of the wiring layer 113 is exposed through the through hole. Next, the protective film 115 is formed on the back surface side of the semiconductor wafer 112' so as to cover a side wall of the through hole. Then, the through electrode 116 embedded in the semiconductor wafer 112' via the protective film 115 is formed. Furthermore, the on-chip lens 117 is formed on the protective film 115. Note that an antireflection film and a color filter may be formed under the on-chip lens 117. Thereafter, by using a method such as dicing, a stacked wafer including the semiconductor wafers 112' and 812' is divided into solid pieces of a chip form to form the packages 800.

In this manner, in the eighth embodiment, in order to electrically connect the upper-layer chip 111 and the lower-layer chip 631 via the intermediate-layer chip 811, the through electrode 816 penetrating the chip 811 is bonded to the pad electrode 114 of the wiring layer 113 of the upper-layer chip 111. Thus, the upper-layer chip 111 and the lower-layer chip 631 can be electrically connected via the chip 811 without forming a back surface wire on the intermediate-layer chip 811.

Note that the chip 511 of the fifth embodiment may be mounted instead of the chip 111 of the eighth embodiment. In addition, a through electrode led out to the lower surface side of the package 800 may be provided to be electrically connected to the outside from the lower surface side of the package 800. For example, instead of the chip 111, the chip 211 of the third embodiment may be provided, and the through electrodes 234 and 235 may be provided on the protective film 639 and connected to the extended rewiring layer 651. Alternatively, instead of the chip 811, the chip 421 and the protective film 427 of the fourth embodiment may be provided, and the through electrode 816 may be formed at the position of the protective film 427.

### <9. Ninth embodiment>

In the eighth embodiment, a film thickness of the insulating layer 815 around the through electrode 816 is equal at the position of the semiconductor layer 812 and at the position of the adhesive layer 821. In a ninth embodiment, the adhesive layer recedes from the semiconductor layer 812 at an embedded position of the through electrode 816, and the film thickness of the insulating layer at the position of the adhesive layer is made larger than the film thickness of the insulating layer at the position of the semiconductor layer 812.

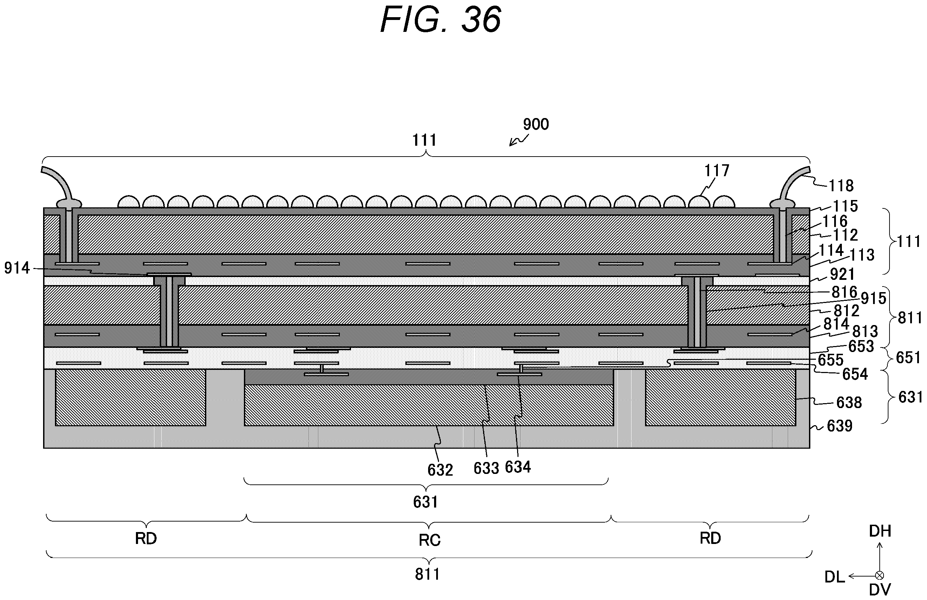

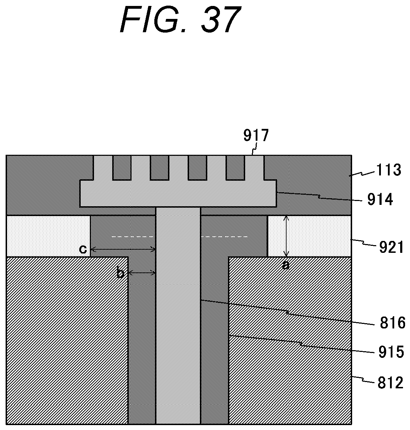

Fig. 36 is a sectional view illustrating a configuration example of a package according to the ninth embodiment, and Fig. 37 is an enlarged sectional view illustrating a part of the package according to the ninth embodiment.

In Fig. 36, a package 900 includes an adhesive layer 921 and an insulating layer 915 instead of the adhesive layer 821 and the insulating layer 815 of the eighth embodiment. Furthermore, in the package 900, the light shielding layer 817 of the eighth embodiment is omitted. Other configurations of the package 900 of the ninth embodiment are similar to the configuration of the package 800 of the eighth embodiment described above.

The adhesive layer 921 bonds the chips 111 and 811 to each other. The adhesive layer 921 recedes from the semiconductor layer 812 at the embedded position of the through electrode 816.

The insulating layer 915 is formed in the semiconductor layer 812, the wiring layer 813, and the adhesive layer 921 so as to surround the outer periphery of the through electrode 816. As illustrated in Fig. 37, a film thickness c of the insulating layer 915 at the position of the adhesive layer 921 is larger than a film thickness b of the insulating layer 915 at the position of the semiconductor layer 812. At this time, a receding portion of the adhesive layer 921 can be embedded with the insulating layer 915. A thickness a of the adhesive layer 921 and the thickness b of the insulating layer 915 at the position of the semiconductor layer 812 near the adhesive layer 921 can satisfy a relationship of a<2b. At the position of the adhesive layer 921, the insulating layer 915 may have a seam in the lateral direction DL. Note that, although Fig. 37 illustrates an example in which a pad electrode 914 is embedded in the insulating layer of the wiring layer 113, the pad electrode 914 may be exposed from the insulating layer of the wiring layer 113 and may be in contact with the adhesive layer 921.

In addition, a plurality of vias 917 is connected to the pad electrode 114 to which the through electrode 816 is bonded, of the pad electrodes 914 provided in the wiring layer 113. The vias 917 can be connected to a surface opposite to a surface to which the through electrode 816 is connected. By connecting the plurality of vias 917 to the through electrode 816, it is possible to improve reliability of connection of the through electrode 816 via the via 917 while coping with an increase in stress caused by the through electrode 816.

Note that, in the package 900 of the ninth embodiment, the light shielding layer 817 of the eighth embodiment is omitted, but the light shielding layer 817 may be provided.

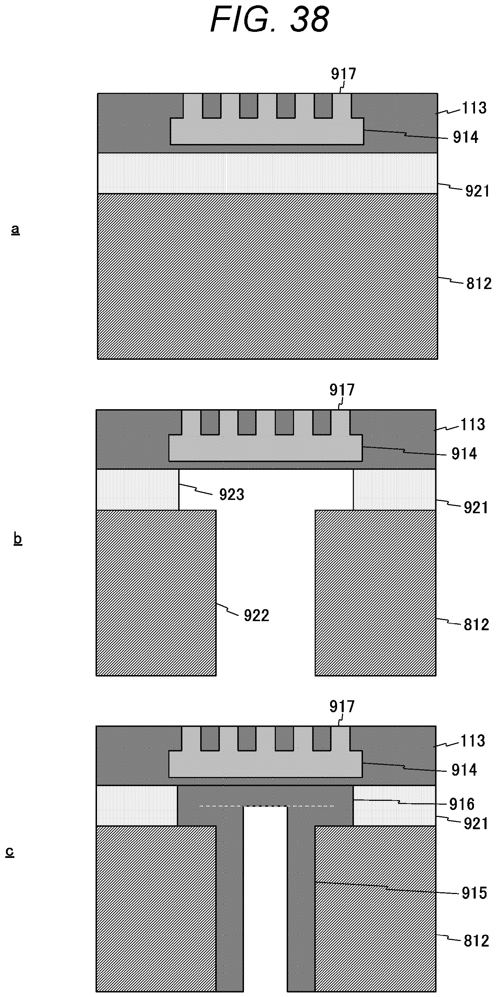

Fig. 38 is a sectional view illustrating an example of a method for manufacturing a through electrode of the package according to the ninth embodiment. Note that, in Fig. 38, similarly to Fig. 37, a part of the package 900 in Fig. 36 is illustrated in an enlarged manner.

In a of the drawing, the wiring layer 113 of the chip 111 is bonded to the semiconductor layer 812 of the chip 811 via the adhesive layer 921. In the wiring layer 113, the pad electrode 914 to which a plurality of vias 917 is connected is formed.

Next, as illustrated in b of the drawing, the semiconductor layer 812 and the adhesive layer 921 are patterned by lithography and dry etching to form through holes 922 and 923. In a case where an etching rate of the adhesive layer 921 is higher than an etching rate of the semiconductor layer 812, side etching proceeds in the adhesive layer 921 as compared with the semiconductor layer 812, and the adhesive layer recedes from the semiconductor layer 812.

Next, as illustrated in "C" of the drawing, the insulating layer 915 is formed in the through holes 922 and 923 so as to cover a side wall of the through hole 922 and a side wall of the through hole 923. At this time, a high-coverage film forming method such as atomic layer deposition (ALD) can be used. In a case where the relationship of a<2b is satisfied, the receding portion of the adhesive layer 921 can be backfilled with the insulating layer 915.

Next, as illustrated in Fig. 37, the insulating layer 915 at a bottom is removed by a method such as plasma etching, and a front surface of the pad electrode 914 is exposed. Then, a through electrode 916 embedded in the semiconductor layer 812 and the adhesive layer 921 via the insulating layer 915 is formed. At this time, the through electrode 916 is connected to the pad electrode 914.

In this manner, in the ninth embodiment, the adhesive layer 921 recedes from the semiconductor layer 812 at the embedded position of the through electrode 816, and the film thickness c of the insulating layer 916 at the position of the adhesive layer 921 is made larger than the film thickness b of the insulating layer 916 at the position of the semiconductor layer 812. Thus, embeddability of the through electrode 816 embedded in the semiconductor layer 812 and the adhesive layer 921 via the insulating layer 916 can be improved, and reliability of the package 900 can be improved.

### <10. Tenth embodiment>

In the ninth embodiment, the plurality of vias 917 connected to the surface opposite to the surface to which the through electrode 816 is connected is evenly arranged in the pad electrode 914. In a tenth embodiment, the via connected to the surface opposite to the surface to which the through electrode 816 is connected is disposed on the pad electrode so as to be separated from an axis of the through electrode 816.

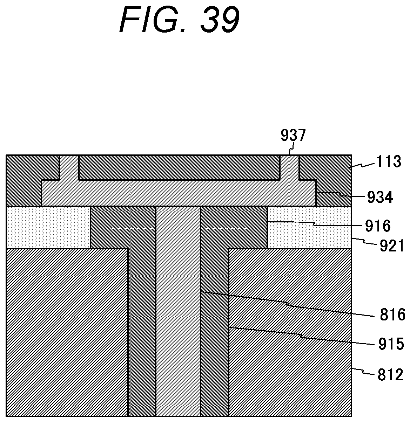

Fig. 39 is a sectional view illustrating a configuration example of a pad electrode of a package according to the tenth embodiment.

In the drawing, in the tenth embodiment, a pad electrode 934 and a via 937 are provided instead of the pad electrode 914 and the via 917 of the ninth embodiment. In addition, the pad electrode 934 is exposed from the insulating layer of the wiring layer 113 and is in contact with the adhesive layer 921. Other configurations of the tenth embodiment are similar to the configuration of the ninth embodiment.

The pad electrode 934 is embedded in the wiring layer 113. At this time, the pad electrode 934 can be exposed from the insulating layer of the wiring layer 113. The through electrode 816 is bonded to the pad electrode 934. In the pad electrode 934, the via 937 is connected to a surface opposite to a surface to which the through electrode 816 is connected. The via 937 is disposed at a position separated from the axis of the through electrode 816. At this time, the via 937 can be prevented from being formed on the axis of the through electrode 816. For example, the through electrode 816 may be bonded to a center of the pad electrode 934, and the via 937 may be bonded to a peripheral part of the pad electrode 934.

In this manner, in the tenth embodiment, the via 937 is disposed at a position separated from the axis of the through electrode 816. Thus, stress caused by the through electrode 816 can be made less likely to be applied to the via 937, and peeling of the via 937 can be suppressed.

### <11. Eleventh embodiment>

In the ninth embodiment, the wiring layer 113 is bonded to the adhesive layer 921, and the through electrode 816 penetrates the adhesive layer 921 and is connected to the pad electrode 914. In an eleventh embodiment, the wiring layer 113 is bonded to the adhesive layer 921 via an etch stopper layer, and the through electrode 816 penetrates the adhesive layer 921 and the etch stopper layer and is connected to the pad electrode.

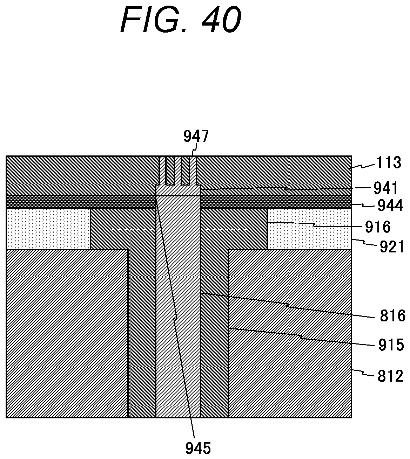

Fig. 40 is a sectional view illustrating a configuration example of a pad electrode of a package according to the eleventh embodiment.

In the drawing, in the eleventh embodiment, the pad electrode 941 and a via 947 are provided instead of the pad electrode 914 and the via 917 of the ninth embodiment. In addition, in the eleventh embodiment, an etch stopper layer 944 is added to the configuration of the ninth embodiment. Other configurations of the eleventh embodiment are similar to the configuration of the ninth embodiment.

The pad electrode 941 is embedded in the wiring layer 113. At this time, the pad electrode 941 can be exposed from the insulating layer of the wiring layer 113. A plurality of vias 947 is connected to the pad electrode 941. The vias 947 can be connected to a surface opposite to a surface to which the through electrode 816 is connected.

The etch stopper layer 944 can be provided between the wiring layer 113 and the adhesive layer 921. In the etch stopper layer 944, a through hole 945 through which the through electrode 816 passes is formed. At this time, the through electrode 816 can be bonded to the pad electrode 941 by self-alignment. The size of a bonding surface of the pad electrode 941 and the size of a bonding surface of the through electrode 816 may be equal to each other. As the material of the etch stopper layer 944, for example, an inorganic film such as SiN can be used.

In this manner, in an eleventh embodiment, the wiring layer 113 is bonded to the adhesive layer 921 via the etch stopper layer 944, and the through electrode 816 penetrates the adhesive layer 921 and the etch stopper layer 944 and is connected to the pad electrode 941. Thus, excessive etching at the time of forming the through hole in which the through electrode 816 is embedded can be suppressed, and an yield and reliability of the package can be improved. In addition, the through electrode 816 can be connected to the pad electrode 941 by self-alignment, and even if misalignment occurs, it is possible to suppress a decrease in yield and reliability and to reduce the area of the pad electrode 941.

### <12. Twelfth embodiment>

In the sixth embodiment, the diameters of the through electrodes 626 embedded in the chip 621 mounted on the package 600 are equal to each other. In a twelfth embodiment, a chip in which through electrodes having different diameters are embedded is mounted on a package.

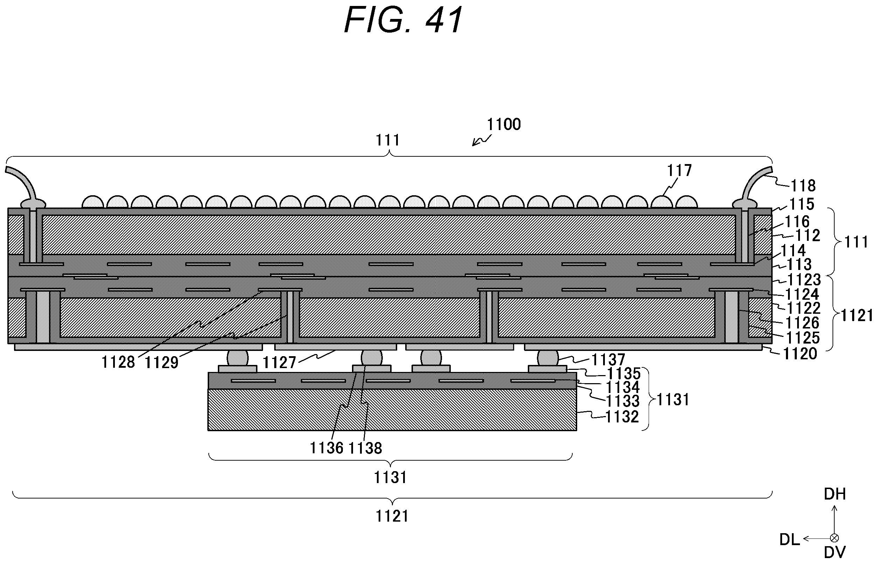

Fig. 41 is a sectional view illustrating a configuration example of a package according to the twelfth embodiment.

In the drawing, a package 1100 includes chips 1121 and 1131 instead of the chips 621 and 631 of the sixth embodiment. In addition, in the package 1100, the extended rewiring layer 651, the dummy chip 638, and the protective film 639 of the sixth embodiment are omitted. Other configurations of the package 1100 of the twelfth embodiment are similar to the configuration of the package 600 of the sixth embodiment.

The chip 1121 is equal in length in the lateral direction DL to the chip 111. At this time, the position of an end of the chip 1121 in the lateral direction DL can be made equal to the position of the end of the chip 111 in the lateral direction DL. The chip 1121 includes a semiconductor layer 1122 and a wiring layer 1123. The wiring layer 1123 is formed on the semiconductor layer 1122. The wiring layer 1123 is provided with a wire embedded in an insulating layer and pad electrodes 1124 and 1128. In addition, through electrodes 1126 and 1129 are embedded in the semiconductor layer 1122. The diameter of the through electrode 1126 is larger than the diameter of the through electrode 1129. The through electrode 1126 can be electrically connected to a power supply line, and the through electrode 1129 can be electrically connected to a signal line. At this time, the through electrode 1126 can be disposed in a power supply wiring region of the chip 1121, and the through electrode 1129 can be disposed in an element region of the chip 1121. The through electrode 1126 is connected to the pad electrode 1124 of the wiring layer 1123. The through electrode 1129 is connected to the pad electrode 1128 of the wiring layer 1123. An insulating layer 1125 is formed on a back surface side of the semiconductor layer 1122. The insulating layer 1125 is formed in the semiconductor layer 1122 so as to surround an outer periphery of each of the through electrodes 1126 and 1129, and can insulate each of the through electrodes 1126 and 1129 from the semiconductor layer 1122. Back surface wires 1120 and 1127 and a pad electrode are formed on the insulating layer 1125. The through electrode 1126 is electrically connected to the back surface wire 1120, and the through electrode 1129 is electrically connected to the back surface wire 1127.

The chip 1131 is shorter in length in the lateral direction DL to the chip 111. The chip 1131 includes a semiconductor layer 1132 and a wiring layer 1133. The wiring layer 1133 is formed on the semiconductor layer 1132. The wiring layer 1133 is provided with a wire 1134 embedded in an insulating layer. In addition, pad electrodes 1135 and 1136 are provided on the insulating layer of the wiring layer 1133. A bump electrode 1137 is formed on the pad electrode 1135, and a bump electrode 1138 is formed on the pad electrode 1136. The pad electrode 1135 is electrically connected to the back surface wire 1120 via the bump electrode 1137, and the pad electrode 1136 is electrically connected to the back surface wire 1127 via the bump electrode 1138.

In this manner, in the twelfth embodiment, the chip 1121 in which the through electrodes 1126 and 1129 having different diameters are embedded is mounted on the package 1100. Thus, the through electrode 1129 having a smaller diameter can be used in a path in which the influence of signal delay is small and a path in which only a minute current flows, and the through electrode 1126 having a larger diameter can be used in a path in which the influence of signal delay is large and a path in which a large current flows. It is therefore possible to embed the through electrodes 1126 and 1129 in the chip 1121 while suppressing a reduction in the number of elements that can be formed in the chip 1121, and it is possible to achieve low signal latency and low power consumption.

Note that a dummy chip may be disposed around the chip 1131, or a protective film covering the chip 1131 may be formed on a back surface side of the chip 1121.

In addition, the through electrodes having different diameters may be applied to the through electrode embedded in the chip 111 of the first embodiment, or may be applied to the through electrode embedded in the chip 121. In addition, the through electrodes having different diameters may be applied to the through electrode embedded in the chip 231 of the second embodiment, may be applied to the through electrode embedded in the dummy chip 238, or may be applied to the through electrode embedded in the protective film 239. In addition, the through electrodes having different diameters may be applied to the through electrode embedded in the protective film 339 of the third embodiment. In addition, the through electrodes having different diameters may be applied to the through electrode embedded in the dummy chip 438 of the fourth embodiment, or may be applied to the through electrode embedded in the protective film 427. In addition, the through electrodes having different diameters may be applied to the through electrode embedded in the chip 811 of the ninth embodiment.

### <13. Thirteenth embodiment>

In the twelfth embodiment, the through electrodes 1126 and 1129 having different diameters are connected to the pad electrodes 1124 and 1128 of the wiring layer 1123, respectively. In a thirteenth embodiment, of the through electrodes 1126 and 1129 having different diameters, the through electrode 1129 having a smaller diameter is connected to an embedded wire embedded in the semiconductor layer.

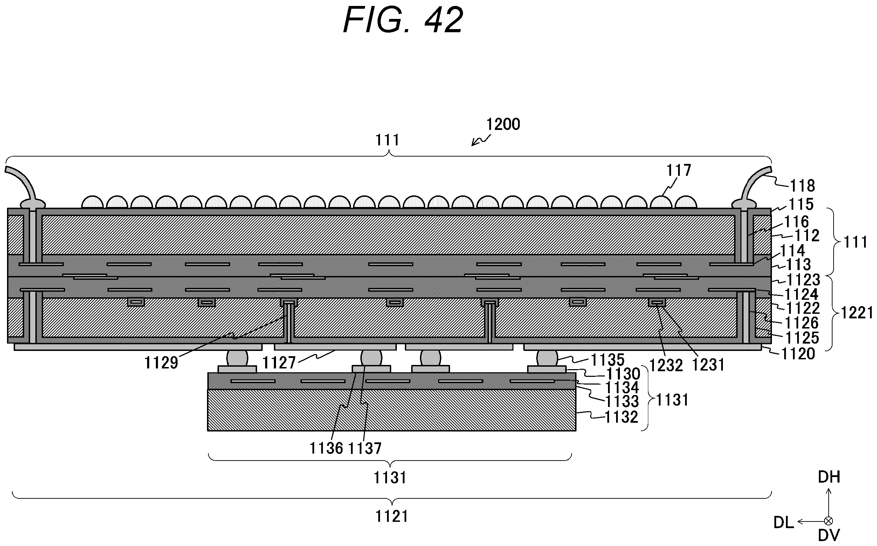

Fig. 42 is a sectional view illustrating a configuration example of a package according to the thirteenth embodiment.

In the drawing, a package 1200 includes a chip 1221 instead of the chip 1121 of the twelfth embodiment. Other configurations of the package 1200 of the thirteenth embodiment are similar to the configuration of the package 1100 of the twelfth embodiment.

In the chip 1221, an embedded wire 1232 is added to the chip 1121 of the twelfth embodiment. In addition, the chip 1121 is provided with an insulating layer 1231 surrounding the embedded wire 1232. Other configurations of the chip 1221 of the thirteenth embodiment are similar to the configuration of the chip 1121 of the twelfth embodiment.

The insulating layer 1231 is embedded in the semiconductor layer 1122. The material of the insulating layer 1231 is, for example, SiO₂. At least a part of the insulating layer 1231 may be used for shallow trench isolation (STI). The embedded wire 1232 is embedded in the insulating layer 1231. The embedded wire 1232 can be connected to the wire of the wiring layer 1123. The material of the embedded wire 1232 may be a metal such as Al or Cu, or may be silicide.

The through electrode 1129 is connected to the embedded wire 1232. At this time, the embedded wire 1232 can be exposed from the insulating layer 1231 at a connection point of the through electrode 1129.

In this manner, in the thirteenth embodiment, of the through electrodes 1126 and 1129 having different diameters, the through electrode 1129 having a smaller diameter is connected to the embedded wire 1232 embedded in the semiconductor layer 1122. Thus, an aspect ratio of the through electrode 1129 can be reduced, and conduction failure of the through electrode 1129 can be suppressed while coping with miniaturization of the through electrode 1129.

Note that the through electrodes connected to the embedded wire embedded in the semiconductor layer may be applied to the through electrode embedded in the chip 111 of the first embodiment, or may be applied to the through electrode embedded in the chip 121. In addition, the through electrodes connected to the embedded wire embedded in the semiconductor layer may be applied to the through electrode embedded in the chip 231 of the second embodiment.

### <14. Fourteenth embodiment>

In the twelfth embodiment, the chip 1121 in which the through electrodes 1126 and 1129 having different diameters are embedded is mounted on the package 1100. In a fourteenth embodiment, a chip in which different numbers of through electrodes connected to pad electrodes are embedded is mounted on a package.

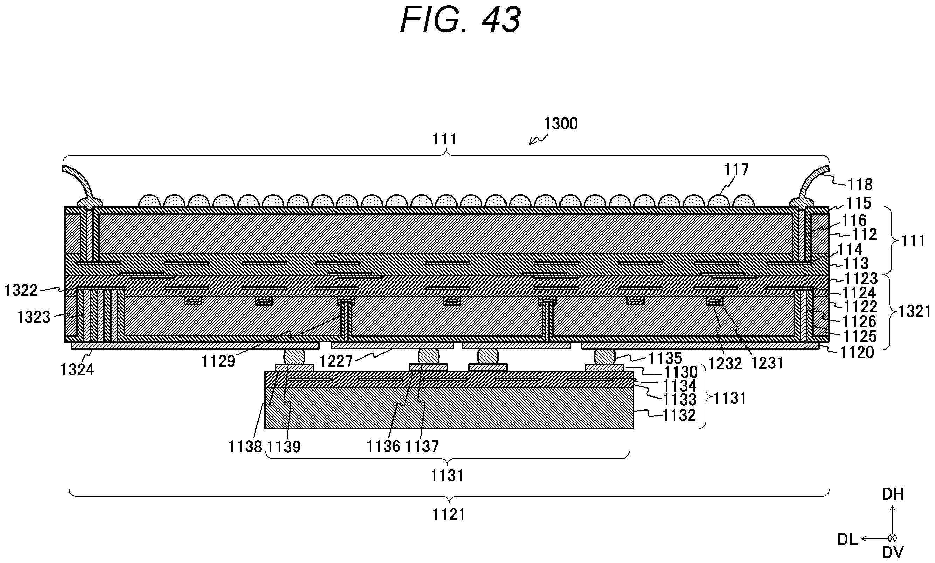

Fig. 43 is a sectional view illustrating a configuration example of a package according to the fourteenth embodiment.

In the drawing, a package 1300 includes a chip 1321 instead of the chip 1221 of the thirteenth embodiment. Other configurations of the package 1300 of the fourteenth embodiment are similar to the configuration of the package 1200 of the thirteenth embodiment.

In the chip 1321, a through electrode 1323 is added to the chip 1221 of the thirteenth embodiment. Other configurations of the chip 1321 of the fourteenth embodiment are similar to the configuration of the chip 1221 of the thirteenth embodiment.

The through electrode 1323 is embedded in the semiconductor layer 1122. The insulating layer 1125 is formed around the through electrode 1323, and the through electrode 1323 is insulated from the semiconductor layer 1122 by the insulating layer 1125. The through electrode 1323 is connected to a pad electrode 1322 of the wiring layer 1123. The number of through electrodes 1323 connected to one pad electrode 1322 is different from the number of through electrodes 1126 connected to the pad electrode 1124. For example, a plurality of through electrodes 1323 can be connected to one pad electrode 1322, and one through electrode 1126 can be connected to the pad electrode 1124. In addition, the diameter of the through electrode 1323 may be smaller than the diameter of the through electrode 1126 or larger than the diameter of the through electrode 1129. The through electrode 1323 can be electrically connected to a power supply line. At this time, the through electrode 1323 can be disposed in a power supply wiring region of the chip 1321. The through electrode 1323 is electrically connected to a back surface wire 1324 formed on the back surface side of the semiconductor layer 1122. The back surface wire 1324 is connected to the pad electrode 1138 of the wiring layer 1131 via a bump electrode 1139.

In this manner, in the fourteenth embodiment, the number of the through electrodes 1323 connected to one pad electrode 1322 is larger than the number of the through electrodes 1126 connected to the pad electrode 1124. Thus, it is possible to reduce a resistance of the through electrode 1323 connected to the pad electrode 1322 while suppressing an increase in the diameter of the through electrode 1323 connected to one pad electrode 1322. It is therefore possible to individually set the resistances of the through electrodes 1126, 1129, and 1323 while achieving uniform embeddability of each of the through electrodes 1126, 1129, and 1323 embedded in the semiconductor layer 1122. As a result, it is possible to achieve low signal latency and low power consumption while suppressing a decrease in reliability of each of the through electrodes 1126, 1129, and 1323, and it is possible to increase the number of elements that can be formed in the chip 1321.

Note that different numbers of through electrodes connected to the pad electrodes may be applied to the through electrode embedded in the chip 111 of the first embodiment, or may be applied to the through electrode embedded in the chip 121. In addition, different numbers of through electrodes connected to the pad electrodes may be applied to the through electrode embedded in the chip 231 of the second embodiment, may be applied to the through electrode embedded in the dummy chip 238, or may be applied to the through electrode embedded in the protective film 239. In addition, different numbers of through electrodes connected to the pad electrodes may be applied to the through electrode embedded in the protective film 339 of the third embodiment. In addition, different numbers of through electrodes connected to the pad electrodes may be applied to the through electrode embedded in the dummy chip 438 of the fourth embodiment, or may be applied to the through electrode embedded in the protective film 427. In addition, different numbers of through electrodes connected to the pad electrodes may be applied to the through electrode embedded in the chip 811 of the ninth embodiment.

### <15. Application example to mobile object>

The technology of the present disclosure (present technology) can be applied to various products. For example, the technology of the present disclosure may be achieved in the form of a device to be mounted on a mobile object of any kind, such as an automobile, an electric vehicle, a hybrid electric vehicle, a motorcycle, a bicycle, a personal mobility, an airplane, a drone, a vessel, or a robot.

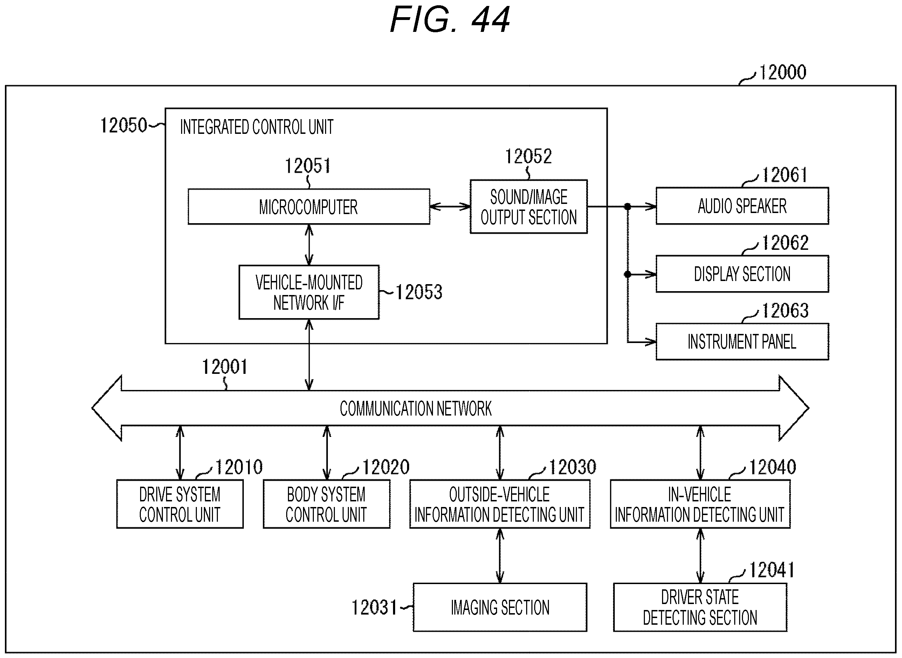

Fig. 44 is a block diagram illustrating an example of a schematic configuration of a vehicle control system as an example of a mobile object control system to which the technology of the present disclosure can be applied.

The vehicle control system 12000 includes a plurality of electronic control units connected to each other via a communication network 12001. In the example illustrated in Fig. 44, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of Fig. 44, an audio speaker 12061, a display section 12062, and an instrument panel 12063 are illustrated as examples of the output device. The display section 12062 may, for example, include at least one of an on-board display and a head-up display.

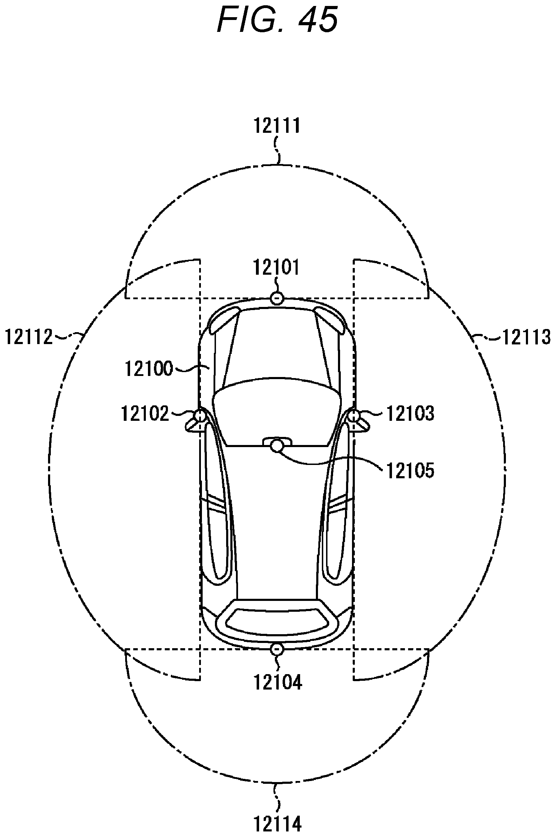

Fig. 45 is a diagram illustrating an example of an installation position of the imaging section 12031.

In Fig. 45, as the imaging section 12031, imaging sections 12101, 12102, 12103, 12104, and 12105 are provided.

The imaging sections 12101, 12102, 12103, 12104, 12105 are provided, for example, at positions such as a front nose, a sideview mirror, a rear bumper, a back door, and an upper portion of a windshield in the interior of a vehicle 12100. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Note that Fig. 45 illustrates an example of imaging ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

An example of the vehicle control system to which the technology of the present disclosure can be applied has been described above. The technology of the present disclosure can not only be applied to the imaging section 12031 and the driver state detecting section 12041 in the above-described configuration, but can also implement at least some functions of the electronic control unit. Specifically, for example, the package 100 in Fig. 1 can implement at least some functions of the electronic control unit while being applied to the imaging section 12031. By applying the technology of the present disclosure to the vehicle control system 12000, it is possible to obtain a captured image while suppressing an increase in the mounting area, and to implement at least some functions of vehicle control.

Note that the embodiments described above show examples for embodying the present technology, and the matters in the embodiments and the matters specifying the invention in the claims have correspondence relationships. Similarly, the matters specifying the invention in the claims and matters with the same names in the embodiments of the present technology have correspondence relationships. However, the present technology is not limited to the embodiments, and can be embodied by applying various modifications to the embodiments without departing from the gist of the present technology. In addition, effects described in the present specification are merely examples and are not limited, and other effects may be provided.

Note that the present technology may also have the following configurations.
(1) A package including
   a first chip having a front surface on which a first wiring layer is formed,
   a second chip having a front surface on which a second wiring layer is formed and having at least a length in a lateral direction that is shorter than the first chip, and
   an extended rewiring layer extended in the lateral direction from the second chip and electrically connected to the first wiring layer and the second wiring layer.
(2) The package according to (1), in which
   a size of the extended rewiring layer is equal to a size of the front surface of the first chip.
(3) The package according to (1) or (2), in which
   the extended rewiring layer is directly bonded to the first wiring layer.
(4) The package according to any of (1) to (3), further including a support member that supports the extended rewiring layer on an extended region extended in the lateral direction from a mounting region of the second chip.
(5) The package according to (4), in which
   the support member includes at least one of a protective film or a dummy chip.
(6) The package according to (4) or (5), further including a through electrode formed in at least one of the first chip, the second chip, or the support member.
(7) The package according to any of (4) to (6), further including an external connection terminal connected to the extended rewiring layer via a through hole formed in the support member.
(8) The package according to any of (1) to (7), further including an extended back surface rewiring layer extended in the lateral direction from the second chip and formed on a back surface side of the second chip.
(9) The package according to (8), further including a third chip that is flip-chip mounted on the extended back surface rewiring layer and has a front surface on which a third wiring layer is formed.
(10) The package according to (9), in which
   the third wiring layer is directly bonded to the extended back surface rewiring layer or bonded to the extended back surface rewiring layer via a bump.
(11) The package according to any of (8) to (10), further including a back surface support member that supports the extended back surface rewiring layer on the back surface side of the second chip in an extended region extended in the lateral direction from the mounting region of the second chip.
(12) The package according to (11), in which
   the back surface support member includes at least one of a protective film or a dummy chip.
(13) The package according to (11) or (12), further including a through electrode formed in at least one of the third chip or the back surface support member.
(14) The package according to any of (9) to (13), further including a support substrate provided on a back surface side of the third chip.
(15) The package according to any of (1) to (14), in which
   any one of the first chip or the second chip is an optical chip disposed in an uppermost layer.
(16) The package according to (15), further including a transparent resin formed on the optical chip.
(17) The package according to (16), further including a transparent substrate disposed on the transparent resin.
(18) The package according to any of (1) to (17), further including a fourth chip in which a fourth wiring layer is formed by being stacked on a back surface of the first chip via an adhesive layer.
(19) The package according to (18), further including a light shielding film formed at a position in contact with the adhesive layer.
(20) The package according to (18) or (19), further including
   a through electrode that penetrates the first chip and the adhesive layer and electrically connects the first wiring layer and the fourth wiring layer, and
   an insulating layer that insulates the through electrode from a semiconductor layer of the first chip, in which
   the adhesive layer recedes from the semiconductor layer of the first chip at an embedded position of the through electrode, and a film thickness of the insulating layer at a position of the adhesive layer is thicker than a film thickness of the insulating layer at a position of the semiconductor layer.
(21) The package according to (20), in which
   a relationship of a<b is satisfied when a film thickness of the adhesive layer is a, and the film thickness of the insulating layer at the position of the semiconductor layer is b.
(22) The package according to (20) or (21), further including
   a pad electrode to which the through electrode is connected, and
   a plurality of vias connected to a surface of the pad electrode opposite to a surface to which the through electrode is connected.
(23) The package according to any of (20) to (22) further including
   a pad electrode to which the through electrode is connected, and
   a via connected to a surface of the pad electrode opposite to a surface to which the through electrode is connected at a position separated from an axis of the through electrode.
(24) The package according to any of (20) to (23), further including
   a pad electrode to which the through electrode is connected, and
   an etch stopper layer formed on the pad electrode and provided with a through hole through which the through electrode passes.
(25) A semiconductor device including
   a first chip having a front surface on which a first wiring layer is formed and including through electrodes having different diameters and electrically connected to the first wiring layer, and
   a second chip having a front surface on which a second wiring layer is formed, the second chip being stacked on the first chip so that the first wiring layer and the second wiring layer face each other.
(26) The semiconductor device according to (25), further including
   a back surface wire formed on a back surface of the first chip, and
   a third chip flip-chip mounted on the back surface wire.
(27) The semiconductor device according to (25) or (26), further including an embedded wire embedded in the semiconductor layer of the first chip, in which
   a through electrode having a smaller diameter of the through electrodes having the different diameters is electrically connected to the first wiring layer via the embedded wire.
(28) The semiconductor device according to any of (25) to (27), in which
   the through electrode includes
   a first through electrode connected to a signal line, and
   a second through electrode connected to a power supply line and having a diameter larger than a diameter of the first through electrode.
(29) A semiconductor device including
   a first chip having a front surface on which a first wiring layer including a plurality of pad electrodes is formed, the first chip including different numbers of through electrodes in contact with the pad electrodes, and
   a second chip having a front surface on which a second wiring layer is formed, the second chip being stacked on the first chip so that the first wiring layer and the second wiring layer face each other.
(30) The semiconductor device according to (29), further including
   a back surface wire formed on a back surface of the first chip, and
   a third chip flip-chip mounted on the back surface wire.
(31) The semiconductor device according to (29) to (30), further including an embedded wire embedded in the semiconductor layer of the first chip, in which
   one through electrode in contact with the pad electrodes, of the different numbers of through electrodes in contact with the pad electrodes, is electrically connected to the first wiring layer via the embedded wire.
(32) The semiconductor device according to any of (29) to (31), in which
   a diameter of a smaller number of through electrodes in contact with the pad electrodes is smaller than a diameter of a larger number of through electrodes in contact with the pad electrodes of the different numbers of through electrodes in contact with the pad electrodes.
(33) A method for manufacturing a package, the method including steps of
   forming a first wiring layer on a wafer to be divided into solid pieces of a first chip,
   arranging a second chip on a support substrate wafer, the second chip having a second wiring layer and being smaller in size than a front surface of the first chip,
   forming a support member on the support substrate wafer, the support member being adjacent to the second chip so as to be equal in size to the front surface of the first chip and being equal in height to the second chip,
   forming an extended rewiring layer equal in size to the front surface of the first chip on the second wiring layer and the support member,
   electrically connecting the first wiring layer and the second wiring layer such that the first wiring layer and the second wiring layer face each other via the extended rewiring layer, and
   dividing the package into solid pieces of packages in which the second chip is stacked on the first chip via the extended rewiring layer.
(34) The method for manufacturing a package according to (33), the method further including steps of
   forming a first through electrode connected to the first wiring layer in the first chip,
   forming a second through electrode connected to the second wiring layer in the second chip,
   forming an extended back surface rewiring layer on a back surface of the second chip and a back surface of the support member, the extended back surface rewiring layer being allowed to be cut out so as to be equal in size to the front surface of the first chip, and
   flip-chip mounting a third chip having a front surface on which a third wiring layer is formed on the extended back surface rewiring layer, in which
   the package is divided into solid pieces of packages in which the second chip is stacked on the first chip via the extended rewiring layer and the third chip is stacked on the second chip via the extended back surface rewiring layer.
(35) The method for manufacturing a package according to (33), the method further including steps of
   forming an extended back surface rewiring layer on a back surface of the second chip and a back surface of the support member, the extended back surface rewiring layer being allowed to be cut out so as to be equal in size to the front surface of the first chip,
   flip-chip mounting a third chip on the extended back surface rewiring layer, the third chip having a third wiring layer and being smaller in size than the front surface of the first chip,
   forming a back surface support member adjacent to the third chip on the extended back surface rewiring layer so as to be equal in size to the front surface of the first chip, and
   forming a through electrode in at least one of the third chip or the back surface support member, in which
   the package is divided into solid pieces of packages in which the second chip is stacked on the first chip via the extended rewiring layer and the third chip is stacked on the second chip via the extended back surface rewiring layer.

### REFERENCE SIGNS LIST

100 Package
111, 121, 131 Chip
112, 122, 132 Semiconductor layer
115 Protective film
141 Extended rewiring layer
116, 126 Through electrode
151 Extended back surface rewiring layer
113, 123, 133 Wiring layer
143, 153 Insulating layer
134, 144 Wire
117 On-chip lens
118 Bonding wire
127, 139 Protective film
154 Back surface rewire
136 Bump electrode
137 Underfill
138 Dummy chip
161 Support substrate

## Claims

1. A package comprising:
a first chip having a front surface on which a first wiring layer is formed;
a second chip having a front surface on which a second wiring layer is formed and having at least a length in a lateral direction that is shorter than the first chip; and
an extended rewiring layer extended in the lateral direction from the second chip and electrically connected to the first wiring layer and the second wiring layer.

2. The package according to claim 1, wherein
a size of the extended rewiring layer is equal to a size of the front surface of the first chip.

3. The package according to claim 1, wherein
the extended rewiring layer is directly bonded to the first wiring layer.

4. The package according to claim 1, further comprising a support member that supports the extended rewiring layer on an extended region extended in the lateral direction from a mounting region of the second chip.

5. The package according to claim 4, wherein
the support member includes at least one of a protective film or a dummy chip.

6. The package according to claim 4, further comprising a through electrode formed in at least one of the first chip, the second chip, or the support member.

7. The package according to claim 4, further comprising an external connection terminal connected to the extended rewiring layer via a through hole formed in the support member.

8. The package according to claim 1, further comprising an extended back surface rewiring layer extended in the lateral direction from the second chip and formed on a back surface side of the second chip.

9. The package according to claim 8, further comprising a third chip that is flip-chip mounted on the extended back surface rewiring layer and has a front surface on which a third wiring layer is formed.

10. The package according to claim 8, wherein
the third wiring layer is directly bonded to the extended back surface rewiring layer or bonded to the extended back surface rewiring layer via a bump.

11. The package according to claim 8, further comprising a back surface support member that supports the extended back surface rewiring layer on the back surface side of the second chip in an extended region extended in the lateral direction from the mounting region of the second chip.

12. The package according to claim 11, wherein
the back surface support member includes at least one of a protective film or a dummy chip.

13. The package according to claim 11, further comprising a through electrode formed in at least one of the third chip or the back surface support member.

14. The package according to claim 9, further comprising a support substrate provided on a back surface side of the third chip.

15. The package according to claim 1, wherein
any one of the first chip or the second chip is an optical chip disposed in an uppermost layer.

16. The package according to claim 15, further comprising a transparent resin formed on the optical chip.

17. The package according to claim 16, further comprising a transparent substrate disposed on the transparent resin.

18. The package according to claim 14, further comprising a fourth chip in which a fourth wiring layer is formed by being stacked on a back surface of the first chip via an adhesive layer.

19. The package according to claim 18, further comprising a light shielding film formed at a position in contact with the adhesive layer.

20. The package according to claim 18, further comprising:
a through electrode that penetrates the first chip and the adhesive layer and electrically connects the first wiring layer and the fourth wiring layer; and
an insulating layer that insulates the through electrode from a semiconductor layer of the first chip, wherein
the adhesive layer recedes from the semiconductor layer of the first chip at an embedded position of the through electrode, and a film thickness of the insulating layer at a position of the adhesive layer is thicker than a film thickness of the insulating layer at a position of the semiconductor layer.

21. The package according to claim 20, wherein
a relationship of a<b is satisfied when a film thickness of the adhesive layer is a, and the film thickness of the insulating layer at the position of the semiconductor layer is b.

22. The package according to claim 20, further comprising:
a pad electrode to which the through electrode is connected; and
a plurality of vias connected to a surface of the pad electrode opposite to a surface to which the through electrode is connected.

23. The package according to claim 20, further comprising:
a pad electrode to which the through electrode is connected; and
a via connected to a surface of the pad electrode opposite to a surface to which the through electrode is connected at a position separated from an axis of the through electrode.

24. The package according to claim 18, further comprising:
a pad electrode to which the through electrode is connected; and
an etch stopper layer formed on the pad electrode and provided with a through hole through which the through electrode passes.

25. A semiconductor device comprising:
a first chip having a front surface on which a first wiring layer is formed and including through electrodes having different diameters and electrically connected to the first wiring layer; and
a second chip having a front surface on which a second wiring layer is formed, the second chip being stacked on the first chip so that the first wiring layer and the second wiring layer face each other.

26. The semiconductor device according to claim 25, further comprising:
a back surface wire formed on a back surface of the first chip; and
a third chip flip-chip mounted on the back surface wire.

27. The semiconductor device according to claim 25, further comprising an embedded wire embedded in the semiconductor layer of the first chip, wherein
a through electrode having a smaller diameter of the through electrodes having the different diameters is electrically connected to the first wiring layer via the embedded wire.

28. The semiconductor device according to claim 25, wherein
the through electrode includes
a first through electrode connected to a signal line, and
a second through electrode connected to a power supply line and having a diameter larger than a diameter of the first through electrode.

29. A semiconductor device comprising:
a first chip having a front surface on which a first wiring layer including a plurality of pad electrodes is formed, the first chip including different numbers of through electrodes in contact with the pad electrodes; and
a second chip having a front surface on which a second wiring layer is formed, the second chip being stacked on the first chip so that the first wiring layer and the second wiring layer face each other.

30. The semiconductor device according to claim 29, further comprising:
a back surface wire formed on a back surface of the first chip; and
a third chip flip-chip mounted on the back surface wire.

31. The semiconductor device according to claim 29, further comprising an embedded wire embedded in the semiconductor layer of the first chip, wherein
one through electrode in contact with the pad electrodes, of the different numbers of through electrodes in contact with the pad electrodes, is electrically connected to the first wiring layer via the embedded wire.

32. The semiconductor device according to claim 29, wherein
a diameter of a smaller number of through electrodes in contact with the pad electrodes is smaller than a diameter of a larger number of through electrodes in contact with the pad electrodes of the different numbers of through electrodes in contact with the pad electrodes.

33. A method for manufacturing a package, the method comprising steps of:
forming a first wiring layer on a wafer to be divided into solid pieces of a first chip;
arranging a second chip on a support substrate wafer, the second chip having a second wiring layer and being smaller in size than a front surface of the first chip;
forming a support member on the support substrate wafer, the support member being adjacent to the second chip so as to be equal in size to the front surface of the first chip and being equal in height to the second chip;
forming an extended rewiring layer equal in size to the front surface of the first chip on the second wiring layer and the support member;
electrically connecting the first wiring layer and the second wiring layer such that the first wiring layer and the second wiring layer face each other via the extended rewiring layer; and
dividing the package into solid pieces of packages in which the second chip is stacked on the first chip via the extended rewiring layer.

34. The method for manufacturing a package according to claim 33, the method further comprising steps of:
forming a first through electrode connected to the first wiring layer in the first chip;
forming a second through electrode connected to the second wiring layer in the second chip;
forming an extended back surface rewiring layer on a back surface of the second chip and a back surface of the support member, the extended back surface rewiring layer being allowed to be cut out so as to be equal in size to the front surface of the first chip; and
flip-chip mounting a third chip having a front surface on which a third wiring layer is formed on the extended back surface rewiring layer, wherein
the package is divided into solid pieces of packages in which the second chip is stacked on the first chip via the extended rewiring layer and the third chip is stacked on the second chip via the extended back surface rewiring layer.

35. The method for manufacturing a package according to claim 33, the method further comprising steps of:
forming an extended back surface rewiring layer on a back surface of the second chip and a back surface of the support member, the extended back surface rewiring layer being allowed to be cut out so as to be equal in size to the front surface of the first chip;
flip-chip mounting a third chip on the extended back surface rewiring layer, the third chip having a third wiring layer and being smaller in size than the front surface of the first chip;
forming a back surface support member adjacent to the third chip on the extended back surface rewiring layer so as to be equal in size to the front surface of the first chip; and
forming a through electrode in at least one of the third chip or the back surface support member, wherein
the package is divided into solid pieces of packages in which the second chip is stacked on the first chip via the extended rewiring layer and the third chip is stacked on the second chip via the extended back surface rewiring layer.
